(19) Europäisches Patentamt / European Patent Office / Office européen des brevets

(11) **EP 2 862 277 B1**

(12) **EUROPÄISCHE PATENTSCHRIFT**

(45) Veröffentlichungstag und Bekanntmachung des Hinweises auf die Patenterteilung:
**29.06.2016 Patentblatt 2016/26**

(51) Int Cl.:
**G01R 17/00** (2006.01)   **G01V 3/02** (2006.01)
**H03K 5/02** (2006.01)   **H03K 17/00** (2006.01)

(21) Anmeldenummer: **13717028.8**

(22) Anmeldetag: **15.04.2013**

(86) Internationale Anmeldenummer:
**PCT/EP2013/057793**

(87) Internationale Veröffentlichungsnummer:
**WO 2013/185948 (19.12.2013 Gazette 2013/51)**

(54) **BALKENDETEKTOR MIT REGELSCHALTUNG**

BEAM DETECTOR WITH CONTROL CIRCUIT

CAPTEUR À CISAILLEMENT AVEC CIRCUIT DE RÉGLAGE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **14.06.2012 DE 102012210004**

(43) Veröffentlichungstag der Anmeldung:
**22.04.2015 Patentblatt 2015/17**

(73) Patentinhaber: **Robert Bosch GmbH**
**70442 Stuttgart (DE)**

(72) Erfinder:
• **ALBRECHT, Andrej**
**70567 Stuttgart (DE)**
• **ZIBOLD, Tobias**
**70567 Stuttgart (DE)**

(56) Entgegenhaltungen:
**EP-A1- 2 589 987     DE-A1-102010 028 723**
**DE-C1- 4 141 264**

EP 2 862 277 B1

**Beschreibung**

Die Erfindung betrifft eine Schaltungsanordnung gemäß Patentanspruch 1 sowie einen Balkendetektor mit einer solchen Schaltungsanordnung gemäß Patentanspruch 10.

Es ist bekannt, kapazitive Sensoren mit rückgekoppelten Brückenschaltungen auszustatten, wie sie beispielsweise in "Capacitive sensors", Larry K. Baxter, IEEE Press beschrieben sind. Auch kapazitive Balkendetektoren zum Aufspüren von in Wänden verborgenen Balken werden mit solchen rückgekoppelten Brückenschaltungen ausgestattet, wie beispielsweise in der DE 10 2010 028 718 beschrieben ist.

Kapazitive Balkendetektoren verwenden bekanntermaßen eine oder mehrere Elektroden, an die Spannungen angelegt werden, wodurch sich elektrische Felder aufbauen. Den Feldern lassen sich Kapazitäten zuordnen. Objekte im Einflussbereich des Balkendetektors verändern die elektrischen Felder und führen zu Änderungen der Kapazitäten.

Die Kapazitätsänderungen sind jedoch sehr klein im Vergleich zu der sich ändernden Kapazität. Dies stellt hohe Anforderungen an die kapazitive Messtechnik der Detektoren.

Offenbarung der Erfindung

Die Aufgabe der vorliegenden Erfindung besteht darin, eine Schaltungsanordnung bereitzustellen, die eine Erkennung einer im Vergleich zu einer Gesamtkapazität kleinen Kapazitätsänderung mit verbesserter Auflösung ermöglicht. Diese Aufgabe wird durch eine Schaltungsanordnung mit den Merkmalen des Anspruchs 1 gelöst. Es ist ferner Aufgabe der vorliegenden Erfindung, einen Balkendetektor mit verbesserter Verlässlichkeit im Hinblick auf Über- und Unterdetektionen und erhöhter Detektionstiefe bereitzustellen. Diese Aufgabe wird durch einen Balkendetektor mit den Merkmalen des Anspruchs 10 gelöst. Bevorzugte Weiterbildungen sind in den abhängigen Ansprüchen angegeben.

Eine erfindungsgemäße Schaltungsanordnung umfasst einen ersten Kondensator, einen zweiten Kondensator und einen dritten Kondensator. Dabei sind erste Kondensatorbeläge der Kondensatoren jeweils mit einem ersten Schaltungsknoten verbunden. Die Kondensatorbeläge können auch als Kondensatorplatten oder als Kondensatorelektroden bezeichnet werden. Diese drei Begriffe werden im Rahmen dieser Anmeldung synonym verwendet.

Die Schaltungsanordnung ist dabei ausgebildet, den ersten Kondensator mit einer ersten zeitabhängigen Spannung zu beaufschlagen, den zweiten Kondensator mit einer zweiten zeitabhängigen Spannung zu beaufschlagen und den dritten Kondensator mit einer dritten zeitabhängigen Spannung zu beaufschlagen. Die erste Spannung und die zweite Spannung sind dabei gegenphasig getaktet, während die zweite Spannung und die dritte Spannung gleichphasig getaktet sind. Die Schaltungsanordnung umfasst außerdem einen Verstärker, einen Synchrondemodulator und einen Komparator. Eingänge des Verstärkers sind mit dem ersten Schaltungsknoten und mit einem Massekontakt verbunden. Der Synchrondemodulator ist dazu vorgesehen, ein Ausgangssignal des Verstärkers synchron zum Takt der ersten Spannung abwechselnd an zwei Eingänge des Komparators anzulegen. Die Schaltungsanordnung ist ferner ausgebildet, in Abhängigkeit von einem Ausgangswert des Komparators einen Regelwert zu generieren. Außerdem ist die Schaltungsanordnung ausgebildet, Amplitudenbeträge der ersten Spannung sowie der dritten Spannung und/oder einen Amplitudenbetrag der zweiten Spannung in Abhängigkeit von dem Regelwert zu verändern. Vorteilhafterweise erlaubt diese Schaltungsanordnung eine Detektion einer im Vergleich zu einem Absolutwert einer Kapazität des ersten Kondensators, des zweiten Kondensators und/oder des dritten Kondensators kleinen Kapazitätsänderung des ersten Kondensators, des zweiten Kondensators und/oder des dritten Kondensators mit hoher Auflösung.

In einer Weiterbildung der Schaltungsanordnung weist diese einen vierten Kondensator auf. Dabei ist ein erster Kondensatorbelag des vierten Kondensators mit dem ersten Schaltungsknoten verbunden. Die Schaltungsanordnung ist dabei ausgebildet, den vierten Kondensator mit einer vierten zeitabhängigen Spannung zu beaufschlagen. Diese vierte Spannung und die erste Spannung sind gleichphasig getaktet. Vorteilhafterweise ergibt sich dann eine symmetrische Ausgestaltung der Schaltungsanordnung, die eine Detektion von kleinen Kapazitätsänderungen der Kondensatoren mit sehr hohem Signal-Rausch-Verhältnis ermöglicht.

In einer Ausführungsform der Schaltungsanordnung weist diese eine regelbare Gleichstromquelle auf, die zwischen dem Massekontakt und einem zweiten Kondensatorbelag des ersten Kondensators oder des zweiten Kondensators oder des dritten Kondensators oder des vierten Kondensators angeordnet ist. Dabei weist die Schaltungsanordnung einen Widerstand auf, der zwischen dem zweiten Kondensatorbelag und einem zweiten Schaltungsknoten angeordnet ist, der dazu vorgesehen ist, sich auf einem gegenüber dem Massekontakt erhöhten konstanten Potential zu befinden. Dabei ist zwischen der Gleichstromquelle und dem zweiten Kondensatorbelag ein Schalter angeordnet. Vorteilhafterweise wirkt der Widerstand dann als Pullup-Widerstand, über den eine Spannung abfällt, deren Größe vom Wert der durch die regelbare Gleichstromquelle ausgegebenen Stromstärke abhängt. Der Kondensator wird mit dieser Spannung beaufschlagt. Der Schalter erlaubt eine Taktung dieser Spannung.

In einer Weiterbildung dieser Schaltungsanordnung weist diese eine erste regelbare Gleichstromquelle, eine zweite regelbare Gleichstromquelle, eine dritte regelbare Gleichstromquelle, eine vierte regelbare Gleichstromquelle, einen ersten Schalter, einen zweiten Schalter, einen dritten Schalter, einen vierten Schalter, einen ersten Widerstand, einen zweiten Widerstand, einen dritten Widerstand und einen vierten Widerstand auf. Dabei ist der erste Schalter zwischen dem zweiten Kondensatorbelag des ersten Kondensators und einem ersten Kontakt der ersten Gleichstromquelle angeordnet. Ein zweiter Kontakt der ersten Gleichstromquelle ist mit dem Massekontakt verbunden. Der erste Widerstand ist zwischen dem zweiten Kondensatorbelag des ersten Kondensators und dem zweiten Schaltungsknoten angeordnet. Der zweite Schalter ist zwischen dem zweiten Kondensatorbelag des zweiten Kondensators und einem ersten Kontakt der zweiten Gleichstromquelle angeordnet. Ein zweiter Kontakt der zweiten Gleichstromquelle ist mit dem Massekontakt verbunden. Der zweite Widerstand ist zwischen dem zweiten Kondensatorbelag des zweiten Kondensators und dem zweiten Schaltungsknoten angeordnet. Der dritte Schalter ist zwischen dem zweiten Kondensatorbelag des dritten Kondensators und einem ersten Kontakt der dritten Gleichstromquelle angeordnet. Ein zweiter Kontakt der dritten Gleichstromquelle ist mit dem Massekontakt verbunden. Der dritte Widerstand ist zwischen dem zweiten Kondensatorbelag des dritten Kondensators und dem zweiten Schaltungsknoten angeordnet. Der vierte Schalter ist zwischen dem zweiten Kondensatorbelag des vierten Kondensators und einem ersten Kontakt der vierten Gleichstromquelle angeordnet. Ein zweiter Kontakt der vierten Gleichstromquelle ist mit dem Massekontakt verbunden. Der vierte Widerstand ist zwischen dem zweiten Kondensatorbelag des vierten Kondensators und dem zweiten Schaltungsknoten angeordnet. Vorteilhafterweise gestatten die vier Gleichstromquellen in Verbindung mit den vier als Pullup-Widerständen wirkenden Widerständen die Erzeugung der vier zeitabhängigen Spannungen, die mittels der vier Schalter getaktet werden können.

In einer anderen Weiterbildung der Schaltungsanordnung weist diese einen invertierenden Verstärker auf. Dabei ist ein invertierender Eingang des invertierenden Verstärkers über einen ersten Widerstand mit dem zweiten Kondensatorbelag verbunden. Ein nicht-invertierender Eingang des invertierenden Verstärkers ist mit einem dritten Schaltungsknoten verbunden, der dazu vorgesehen ist, sich auf einem konstanten Potential zu befinden, das mittig zwischen dem Potential des zweiten Schaltungsknotens und dem Potential des Massekontakts liegt. Ein Ausgang des invertierenden Verstärkers ist über einen zweiten Widerstand mit dem invertierenden Eingang des invertierenden Verstärkers verbunden. Außerdem ist der Ausgang des invertierenden Verstärkers mit einem weiteren zweiten Kondensatorbelag eines weiteren Kondensators verbunden. Vorteilhafterweise können in dieser Weiterbildung der Schaltungsanordnung zwei der zeitabhängigen Spannungen mit nur einer Gleichstromquelle erzeugt werden. Die Verwendung des invertierenden Verstärkers bewirkt dabei eine gegenphasige Taktung der beiden Spannungen.

In einer alternativen Ausführungsform der Schaltungsanordnung weist diese eine regelbare Gleichspannungsquelle auf, die zwischen dem Massekontakt und einem zweiten Kondensatorbelag des ersten Kondensators oder des zweiten Kondensators oder des dritten Kondensators oder des vierten Kondensators angeordnet ist. Dabei ist zwischen der Gleichspannungsquelle und dem zweiten Kondensatorbelag ein weiterer Schalter angeordnet, der dazu ausgebildet ist, den zweiten Kondensatorbelag entweder mit der Gleichspannungsquelle oder mit dem Massekontakt zu verbinden. Vorteilhafterweise kann bei dieser Ausführungsform der Schaltungsanordnung eine der zeitabhängigen Spannung mittels der regelbaren Gleichspannungsquelle erzeugt werden. Der Schalter erlaubt dabei eine Taktung der an den Kondensator angelegten Spannung.

In einer Weiterbildung der Schaltungsanordnung weist diese einen Taktgenerator auf, der dazu ausgebildet ist, ein Taktsignal und ein zum Taktsignal inverses Gegentaktsignal zu erzeugen. Die Schaltungsanordnung ist dabei ausgebildet, den Synchrondemodulator mittels des Taktsignals anzusteuern. Außerdem ist die Schaltungsanordnung ausgebildet, die erste Spannung mittels des Taktsignals zu takten und die zweite Spannung mittels des Gegentaktsignals zu takten. Vorteilhafterweise weisen die erste Spannung und die zweite Spannung dann gegenphasige Taktungen auf.

In einer weiteren alternativen Ausführungsform der Schaltungsanordnung weist diese eine regelbare Wechselstromquelle auf, die zwischen dem Massekontakt und einem zweiten Kondensatorbelag des ersten Kondensators oder des zweiten Kondensators oder des dritten Kondensators oder des vierten Kondensators angeordnet ist. Dabei weist die Schaltungsanordnung außerdem einen Widerstand auf, der zwischen dem zweiten Kondensatorbelag und einem zweiten Schaltungsknoten angeordnet ist, der dazu vorgesehen ist, sich auf einem gegenüber dem Massekontakt erhöhten konstanten Potential zu befinden. Vorteilhafterweise wirkt der Widerstand bei dieser Ausführungsform der Schaltungsanordnung als Pullup-Widerstand, über den eine Spannung abfällt, die von der Stromstärke des durch die regelbare Wechselstromquelle ausgegebenen Stroms abhängt. Diese Spannung wird an einen der Kondensatoren angelegt. Vorteilhafterweise ist durch die Zeitabhängigkeit des durch die regelbare Wechselstromquelle ausgegebenen Stroms auch eine Zeitabhängigkeit der über den Kondensator abfallenden Spannung gewährleistet.

In einer bevorzugten Ausführungsform der Schaltungsanordnung ist der Komparator ein integrierender Komparator oder ein Sample-and-Hold-Komparator. Vorteilhafterweise erlaubt der Komparator dann einen Vergleich der während beider Taktphasen der gegenphasig getakteten Spannungen vom Verstärker ausgegebenen Signale.

Ein erfindungsgemäßer Balkendetektor weist eine Schaltungsanordnung der vorgenannten Art auf. Vorteilhafterweise erlaubt der Balkendetektor dann eine Detektion von Objekten mit verbesserter Empfindlichkeit. Hierdurch sinkt vorteilhafterweise die Gefahr von Fehldetektionen, also von Über- und Unterdetektionen. Außerdem steigt vorteilhafterweise die maximale Detektionstiefe des Balkendetektors.

In einer bevorzugten Ausführungsform des Balkendetektors weist dieser eine erste Elektrode und eine zweite Elektrode auf. Dabei bildet die erste Elektrode den zweiten Kondensatorbelag des ersten Kondensators. Die zweite Elektrode bildet den ersten Kondensatorbelag des ersten Kondensators. Vorteilhafterweise ändert sich dann die Kapazität des ersten Kondensators, wenn der Balkendetektor an ein Objekt angenähert wird. Dies kann vorteilhafterweise mit hohem Signal-Rausch-Verhältnis durch die Schaltungsanordnung detektiert werden.

In einer Weiterbildung des Balkendetektors weist dieser eine dritte Elektrode auf. Dabei bilden die erste Elektrode und die dritte Elektrode gemeinsam den zweiten Kondensatorbelag des ersten Kondensators. Vorteilhafterweise ergibt sich dann eine symmetrische Ausgestaltung des Balkendetektors.

In einer zusätzlichen Weiterbildung des Balkendetektors ist die Schaltungsanordnung mit einem vierten Kondensator ausgebildet. Dabei weist der Balkendetektor eine vierte Elektrode und eine fünfte Elektrode auf. Die vierte Elektrode und die fünfte Elektrode bilden gemeinsam den zweiten Kondensatorbelag des zweiten Kondensators oder des dritten Kondensators oder des vierten Kondensators. Dabei bildet die zweite Elektrode den ersten Kondensatorbelag dieses Kondensators. Vorteilhafterweise weist auch dieser Balkendetektor eine symmetrische Ausgestaltung auf. Dabei ändern sich bei diesem Balkendetektor vorteilhafterweise Kapazitäten zweier Kondensatoren, wenn der Balkendetektor an ein Objekt angenähert wird. Vorteilhafterweise kann dies mit hoher Auflösung durch die Schaltungsanordnung detektiert werden.

In einer alternativen Weiterbildung des Balkendetektors weist dieser eine dritte Elektrode auf. Dabei bilden die dritte Elektrode und die zweite Elektrode den zweiten Kondensator, den dritten Kondensator oder den vierten Kondensator. Vorteilhafterweise ändern sich auch in dieser Ausführungsform des Balkendetektors zwei Kapazitäten, wenn der Balkendetektor an ein Objekt angenähert wird.

In einer Weiterbildung dieses Balkendetektors ist die Schaltungsanordnung mit vier Kondensatoren ausgebildet. Der Balkendetektor weist dabei eine vierte Elektrode und eine fünfte Elektrode auf. Die vierte Elektrode und die zweite Elektrode sowie die fünfte Elektrode und die zweite Elektrode bilden die beiden nicht mit der ersten Elektrode und mit der dritten Elektrode gebildeten Kondensatoren. Vorteilhafterweise ändern sich bei diesem Balkendetektor die Kapazitäten aller vier Kondensatoren, wenn der Balkendetektor an ein Objekt angenähert wird.

In einer bevorzugten Ausführungsform des Balkendetektors ist die zweite Elektrode zwischen der ersten Elektrode und der dritten Elektrode angeordnet. Vorteilhafterweise erlaubt der Balkendetektor je nach Verschaltung der Elektroden dann eine absolute oder eine differenzielle Messung einer Annäherung des Balkendetektors an ein Objekt.

Es ist zweckmäßig, dass die nicht durch Elektroden gebildeten Kondensatoren der Schaltungsanordnung des Balkendetektors als Festwertkondensatoren ausgebildet sind. Vorteilhafterweise ändern sich die Kapazitäten der als Festwertkondensatoren ausgebildeten Kondensatoren dann bei Annäherung des Balkendetektors an ein Objekt nicht.

In einer bevorzugten Ausführungsform des Balkendetektors sind die Elektroden als metallische Platten ausgebildet. Beispielsweise können die Elektroden als metallische Flächen auf einer Leiterplatte ausgebildet sein. Vorteilhafterweise ändert sich die Kapazität der Elektroden dann, wenn der Balkendetektor an ein Objekt angenähert wird.

Die Erfindung wird nun anhand der beigefügten Figuren näher erläutert. Dabei zeigen:

Fig. 1 eine schematische Darstellung einer Schaltungsanordnung;

Fig. 2 einen Ausschnitt einer alternativen Schaltungsanordnung;

Fig. 3 einen Ausschnitt einer weiteren alternativen Schaltungsanordnung;

Fig. 4 eine schematische Darstellung einer weiteren alternativen Schaltungsanordnung;

Fig. 5 eine schematische Darstellung eines prototypischen Balkendetektors;

Figuren 6 und 7 schematische Darstellungen zweier Balkendetektoren für absolute Messungen mit zwei angeregten Elektroden;

Figuren 8 und 9 schematische Darstellungen von Balkendetektoren mit zwei angeregten Elektroden für differenzielle Messungen;

Fig. 10 einen Graphen zum Vergleich absoluter und differenzieller Messungen;

Figuren 11 bis 14 schematische Darstellungen von Balkendetektoren mit fünf Elektroden für differenzielle Messungen;

Figuren 15 bis 18 schematische Darstellungen des Messverhaltens der Balkendetektoren;

Figuren 19 und 20 schematische Darstellungen von Balkendetektoren mit fünf Elektroden für absolute Messungen;

Figuren 21 und 22 schematische Darstellungen des Messverhaltens dieser Balkendetektoren;

Figuren 23, 24 und 25 schematische Darstellungen weiterer Balkendetektoren mit fünf Elektroden für absolute Messungen;

Figuren 26, 27 und 28 schematische Darstellungen des Messverhaltens dieser Balkendetektoren; und

Figuren 29 bis 32 elektrische Felder, die sich für Balkendetektoren unterschiedlicher Konfigurationen ergeben.

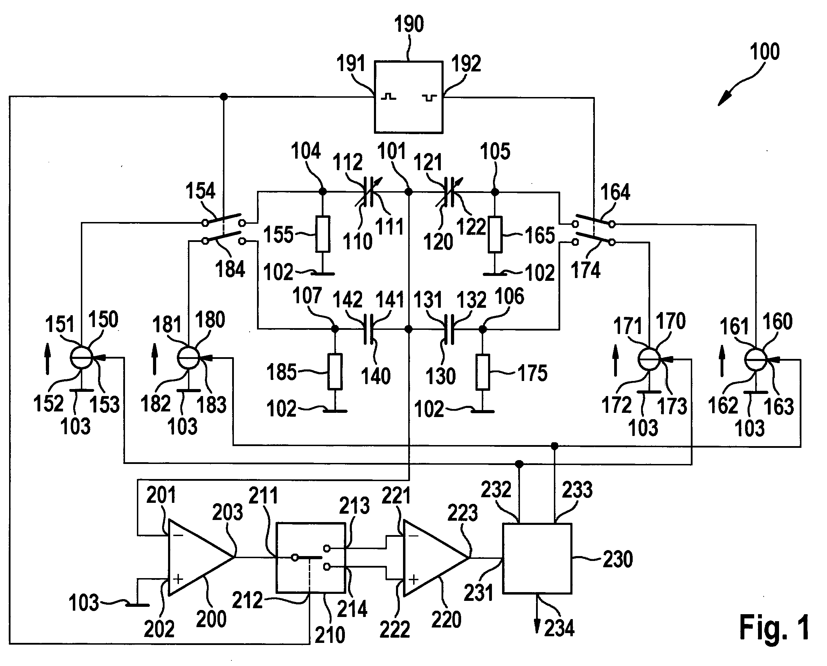

Fig. 1 zeigt in schematisierter Darstellung eine Schaltungsanordnung 100. Die Schaltungsanordnung 100 dient als Regelschaltung zur Detektion von Veränderungen von Kapazitäten eines oder mehrerer Kondensatoren. Die Schaltungsanordnung 100 kann beispielsweise in kapazitiven Detektoren, insbesondere in kapazitiven Balkendetektoren, verwendet werden.

Die Schaltungsanordnung 100 weist einen ersten Schaltungsknoten 101, einen zweiten Schaltungsknoten 102 und einen Massekontakt 103 auf. Der zweite Schaltungsknoten 102 befindet sich im Betrieb der Schaltungsanordnung 100 auf einem gegenüber dem Massekontakt 103 erhöhten Potential, sodass zwischen dem zweiten Schaltungsknoten 102 und dem Massekontakt 103 eine Spannung Vcc anliegt. Außerdem umfasst die Schaltungsanordnung 100 einen vierten Schaltungsknoten 104, einen fünften Schaltungsknoten 105, einen sechsten Schaltungsknoten 106 und einen siebten Schaltungsknoten 107.

Die Schaltungsanordnung 100 weist einen ersten Kondensator 110, einen zweiten Kondensator 120, einen dritten Kondensator 130 und einen vierten Kondensator 140 auf. Der erste Kondensator 110 weist einen ersten Kondensatorbelag 111 und einen zweiten Kondensatorbelag 112 auf. Die Kondensatorbeläge 111, 112 können auch als Kondensatorplatten oder als Kondensatorelektroden bezeichnet werden. Der zweite Kondensator 120 weist einen ersten Kondensatorbelag 121 und einen zweiten Kondensatorbelag 122 auf. Der dritte Kondensator 130 weist einen ersten Kondensatorbelag 131 und einen zweiten Kondensatorbelag 132 auf. Der vierte Kondensator 140 weist einen ersten Kondensatorbelag 141 und einen zweiten Kondensatorbelag 142 auf. Die ersten Kondensatorbeläge 111, 121, 131, 141 der Kondensatoren 110, 120, 130, 140 sind mit dem ersten Schaltungsknoten 101 verbunden.

Die Schaltungsanordnung 100 weist außerdem eine erste Gleichstromquelle 150, eine zweite Gleichstromquelle 160, eine dritte Gleichstromquelle 170 und eine vierte Gleichstromquelle 180 auf. Die vier Gleichstromquellen 150, 160, 170, 180 sind regelbare Gleichstromquellen, die dazu vorgesehen sind, Gleichströme mit regelbarer Amplitude auszugeben. Die erste Gleichstromquelle 150 weist einen ersten Kontakt 151, einen zweiten Kontakt 152 und einen Steuerkontakt 153 auf. Die zweite Gleichstromquelle 160 weist einen ersten Kontakt 161, einen zweiten Kontakt 162 und einen Steuerkontakt 163 auf. Die dritte Gleichstromquelle 170 weist einen ersten Kontakt 171, einen zweiten Kontakt 172 und einen Steuerkontakt 173 auf. Die vierte Gleichstromquelle 180 weist einen ersten Kontakt 181, einen zweiten Kontakt 182 und einen Steuerkontakt 183 auf. Die zweiten Kontakte 152, 162, 172, 182 der Gleichstromquellen 150, 160, 170, 180 sind jeweils mit dem Massekontakt 103 verbunden. Über die Steuerkontakte 153, 163, 173, 183 kann den Gleichstromquellen 150, 160, 170, 180 jeweils ein Steuerwert vorgegeben werden, der die Größe der durch die Gleichstromquellen 150, 160, 170, 180 über ihre Kontakte 151, 152, 161, 162, 171, 172, 181, 182 ausgegebenen Stromstärken festlegt.

Die Schaltungsanordnung 100 umfasst außerdem einen ersten Schalter 154, einen ersten Pullup-Widerstand 155, einen zweiten Schalter 164, einen zweiten Pullup-Widerstand 165, einen dritten Schalter 174, einen dritten Pullup-Widerstand 175, einen vierten Schalter 184 und einen vierten Pullup-Widerstand 185. Der zweite Kondensatorbelag 112 des ersten Kondensators 110 ist mit dem vierten Schaltungsknoten 104 verbunden. Der erste Pullup-Widerstand 155 ist zwischen dem vierten Schaltungsknoten 104 und dem zweiten Schaltungsknoten 102 angeordnet. Der erste Schalter 154 ist zwischen dem vierten Schaltungsknoten 104 und dem ersten Kontakt 151 der ersten Gleichstromquelle 150 angeordnet. Der zweite Kondensatorbelag 122 des zweiten Kondensators 120 ist mit dem fünften Schaltungsknoten 105 verbunden. Der zweite Pullup-Widerstand 165 ist zwischen dem fünften Schaltungsknoten 105 und dem zweiten Schaltungsknoten 102 angeordnet. Der zweite Schalter 164 ist zwischen dem fünften Schaltungsknoten 105 und dem ersten Kontakt 161 der zweiten Gleichstromquelle 160 angeordnet. Der zweite Kondensatorbelag 132 des dritten Kondensators 130 ist mit dem sechsten Schaltungsknoten 106 verbunden. Der dritte Pullup-Widerstand 175 ist zwischen dem sechsten Schaltungsknoten 106 und dem zweiten Schaltungsknoten 102 angeordnet. Der dritte Schalter 164 ist zwischen dem sechsten Schaltungsknoten 106 und dem ersten Kontakt 171 der dritten Gleichstromquelle 170 angeordnet. Der zweite Kondensatorbelag 142 des vierten Kondensators 140 ist mit dem siebten Schaltungsknoten 107 verbunden. Der vierte Pullup-Widerstand 185 ist zwischen dem siebten Schaltungsknoten 107 und dem zweiten Schaltungsknoten 102 angeordnet. Der vierte Schalter 184 ist zwischen dem siebten Schaltungsknoten 107 und dem ersten Kontakt 181 der vierten Gleichstromquelle 180 angeordnet.

Die Schaltungsanordnung 100 umfasst außerdem einen Taktgenerator 190 mit einem Taktsignalausgang 191 und einem Gegentaktsignalausgang 192. Der Taktgenerator 190 ist dazu ausgebildet, ein Taktsignal mit einer festgelegten Frequenz über den Taktsignalausgang 191 auszugeben. Außerdem ist der Taktgenerator 190 ausgebildet, über den Gegentaktsignalausgang 192 ein Gegentaktsignal auszugeben, das gegenüber dem über dem Taktsignalausgang 191 ausgegebenen Taktsignal um 180° phasenverschoben ist. Die Schaltungsanordnung 100 ist ausgebildet, den ersten Schalter 154 und den vierten Schalter 184 synchron zum über den Taktsignalausgang 191 ausgegebenen Taktsignal zu schalten. Außerdem ist die Schaltungsanordnung 100 ausgebildet, den zweiten Schalter 164 und den dritten Schalter 174 synchron zum über den Gegentaktsignalausgang 192 ausgegebenen Gegentaktsignal zu schalten.

Die Schaltungsanordnung 100 umfasst ferner einen Verstärker 200, einen Synchrondemodulator 210, einen Komparator 220 und einen Regelwerterzeuger 230. Der Verstärker weist einen negativen Eingang 201, einen positiven Eingang 202 und einen Ausgang 203 auf. Der negative Eingang 201 des Verstärkers 200 ist mit dem ersten Schaltungsknoten 101 der Schaltungsanordnung 100 verbunden. Der positive Eingang 202 des Verstärkers 200 ist mit dem Massekontakt 103 verbunden. Der Synchrondemodulator 210 weist einen Signaleingang 211, einen Modulationseingang 212, einen ersten Ausgang 213 und einen zweiten Ausgang 214 auf. Der Signaleingang 211 des Synchrondemodulators 210 ist mit dem Ausgang 203 des Verstärkers 200 verbunden. Der Modulationseingang 212 ist mit dem Taktsignalausgang 191 des Taktgenerators 190 verbunden. Der Komparator 220 weist einen ersten Eingang 221, einen zweiten Eingang 222 und einen Ausgang 223 auf. Der erste Eingang 221 ist mit dem ersten Ausgang 213 des Synchrondemodulators 210 verbunden. Der zweite Eingang 222 des Komparators 220 ist mit dem zweiten Ausgang 214 des Synchrondemodulators 210 verbunden. Der Regelwerterzeuger 230 weist einen Abweichungseingang 231, einen ersten Steuersignalausgang 232, einen zweiten Steuersignalausgang 233 und einen Regelwertausgang 234 auf. Der Abweichungseingang 231 ist mit dem Ausgang 223 des Komparators 220 verbunden. Der erste Steuersignalausgang 232 ist mit dem Steuerkontakt 153 der ersten Gleichstromquelle 150 und mit dem Steuerkontakt 173 der dritten Gleichstromquelle 170 verbunden. Der zweite Steuersignalausgang 233 des Regelwerterzeugers 230 ist mit dem Steuerkontakt 163 der zweiten Gleichstromquelle 160 und mit dem Steuerkontakt 183 der vierten Gleichstromquelle 180 verbunden.

Die erste Gleichstromquelle 150 erzeugt einen Strom $I_A$. Die zweite Gleichstromquelle 160 erzeugt einen Strom $I_B$. Die dritte Gleichstromquelle 170 erzeugt einen Strom $I_{-A}$. Die vierte Gleichstromquelle 180 erzeugt einen Strom $I_{-B}$. Die Ströme $I_A$ und $I_{-B}$ der ersten Gleichstromquelle 150 und der vierten Gleichstromquelle 180 werden durch den ersten Schalter 154 und den vierten Schalter 184 im Takt des über den Taktsignalausgang 191 des Taktgenerators 190 ausgegebenen Taktsignals unterbrochen. Die Ströme $I_B$ und $I_{-A}$ der zweiten Gleichstromquelle 160 und der dritten Gleichstromquelle 170 werden mittels des zweiten Schalters 164 und des dritten Schalters 174 im Takt des über den Gegentaktsignalausgang 192 des Taktgenerators 190 ausgegebenen Gegentaktsignals unterbrochen. An den vier Pullup-Widerständen 155, 165, 175, 185 fallen zu den Strömen $I_A$, $I_B$, $I_{-A}$, $I_{-B}$ proportionale Spannungen ab, die gegenüber dem gemeinsamen Bezugspotential am ersten Schaltungsknoten 101 an den vier Kondensatoren 110, 120, 130, 140 anliegen. Der erste Schaltungsknoten 101 bildet eine virtuelle Masse.

Das am Ausgang 203 des Verstärkers 200 ausgegebene Signal wird durch den Synchrondemodulator 210 taktsynchron zum über den Taktsignalausgang 191 ausgegebenen Taktsignal alternierend an die beiden Eingänge 221, 222 des Komparators 220 angelegt. Der Komparator 220 kann beispielsweise ein integrierender Komparator oder ein Sample-and-Hold-Komparator sein. Falls der Komparator 220 als integrierender Komparator ausgebildet ist, so vergleicht er das Integral des über den Ausgang 203 des Verstärkers 200 ausgegebenen Signals während der ersten Hälfte eines Taktes mit dem Integral dieses Signals während der zweiten Hälfte eines Taktes. Falls der Komparator 220 als Sample-and-Hold-Komparator ausgebildet ist, so vergleicht er das über den Ausgang 203 des Verstärkers 200 ausgegebene Signal zu einem Zeitpunkt in der ersten Hälfte des Taktes mit dem Signal zu einem korrespondierenden Zeitpunkt in der zweiten Hälfte des Taktes. Der Komparator 220 gibt ein von diesem Vergleich abhängiges Komparatorsignal über seinen Ausgang 223 aus.

Der Regelwerterzeuger 230 erzeugt in Abhängigkeit von diesem über den Abweichungseingang 231 empfangenen Komparatorsignal einen Regelwert n. Hierzu kann der Regelwerterzeuger 230 proportionale, integrale und differenzielle Komponenten aufweisen. Der Regelwerterzeuger 230 kann beispielsweise digital ausgebildet sein.

Der Regelwerterzeuger 230 erzeugt außerdem ein erstes Steuersignal $I_1$, das über den ersten Steuersignalausgang 232 ausgegeben wird, und ein zweites Steuersignal $I_2$, das über den zweiten Steuersignalausgang 233 ausgegeben wird. Das erste Steuersignal $I_1$ ist die Summe eines Offsetwertes $I_0$ und dem n-fachen eines Bereichswertes $I_\Delta$: $I_1 = I_0 + nI_\Delta$. Das zweite Steuersignal $I_2$ ist die Differenz des Offsetwertes $I_0$ und dem n-fachen des Bereichswertes $I_\Delta$: $I_2 = I_0 - nI_\Delta$. Damit ändert der Regelwert n die beiden Steuersignale $I_1$, $I_2$ gegenläufig um den Offsetwert $I_0$. Das erste Steuersignal $I_1$ wird über den ersten Steuersignalausgang 232 des Regelwerterzeugers 230 der ersten Gleichstromquelle 150 und der dritten Gleichstromquelle 170 als Steuersignal zugeführt und bestimmt die Amplituden der durch die Gleichstromquellen 150, 170 ausgegebenen Ströme $I_A$ und $I_{-A}$. Das zweite Steuersignal $I_2$ wird über den zweiten Steuersignalausgang 233 des Regelwerterzeugers 230 der zweiten Gleichstromquelle 160 und der vierten Gleichstromquelle 180 als Regelwert zugeführt und bestimmt die Amplituden der durch die Gleichstromquellen 160, 180 ausgegebenen Ströme $I_B$ und $I_{-B}$.

Über die von dem Regelwert n abhängige Steuerung der Amplituden der durch die Gleichstromquellen 150, 160, 170, 180 ausgegebenen Stromstärken $I_A$, $I_{-A}$, $I_B$, $I_{-B}$ wird ein taktsynchroner Anteil im am negativen Eingang 201 des Verstärkers 200 anliegenden Signal auf den Vergleichswert am positiven Eingang 202 des Verstärkers 200, also auf das Potential des Massekontakts 103, ausgeregelt. Je nachdem, ob der Komparator 220 als integrierender Komparator oder als Sample-and-Hold-Komparator ausgebildet ist, gilt dies für den gesamten Takt oder nur für die Abtastzeitpunkte. Hierdurch wird der erste Schaltungsknoten 101 zu einer virtuellen Masse.

Da die Schaltungsanordnung 100 die Differenz zwischen den an den Eingängen 201, 202 des Verstärkers 200 anliegenden Signalen zu null regelt, kann der Verstärker 200 mit sehr hohem Verstärkungsfaktor ausgebildet sein. Hierdurch ergibt sich ein sehr gutes Signal-Rausch-Verhältnis der Schaltungsanordnung 100.

Der erste Kondensator 110 weist eine Kapazität $C_{mess}$ auf. Der zweite Kondensator 120 weist eine Kapazität $C_{ref}$ auf. Der dritte Kondensator 130 weist eine Kapazität $C_{komp,mess}$ auf. Der vierte Kondensator 140 weist eine Kapazität $C_{komp,ref}$ auf. Die Pullup-Widerstände 155, 165, 175, 185 weisen jeweils einen Widerstandswert $R_P$ auf. Im Grenzfall $R_P \to 0$ gilt:

$$n = \frac{I_0 \left( \left\lfloor C_{mess} - C_{komp,mess} \right\rfloor - \left\lfloor C_{ref} - C_{komp,ref} \right\rfloor \right)}{I_\Delta \left( \left\lfloor C_{mess} - C_{komp,mess} \right\rfloor + \left\lfloor C_{ref} - C_{komp,ref} \right\rfloor \right)}. \qquad \text{(Gleichung 1)}.$$

Der Regelwert n ist wohldefiniert, solange der Nenner in Gleichung 1 ungleich null ist. Die Schaltungsanordnung 100 der Fig. 1 regelt allerdings nur, falls $C_{mess}$ größer als $C_{komp,mess}$ und $C_{ref}$ größer als $C_{komp,ref}$ ist. Tauscht man die Zuordnung der Ausgänge 213, 214 des Synchrondemodulators 210 zu den Eingängen 221, 222 des Komparators 220, so regelt die Schaltungsanordnung 100, wenn $C_{mess}$ kleiner als $C_{komp,mess}$ und $C_{ref}$ kleiner als $C_{komp,ref}$ ist. Denselben Effekt bewirkt auch ein Invertieren der Eingangssignale des Verstärkers 200.

Die Kapazitäten $C_{mess}$ und $C_{ref}$ sind variabel und weisen jeweils einen fixen Anteil $C_{mess,0}$, $C_{ref,0}$ und einen variablen Anteil $\Delta_{mess}$ und $\Delta_{ref}$ auf. Somit gilt:

$$C_{mess} = C_{mess,0} + \Delta_{mess}$$

$$C_{ref} = C_{ref,0} + \Delta_{ref}.$$

Durch die Wahl $C_{komp,mess} = C_{mess,0} - \varepsilon$ und $C_{komp,ref} = C_{ref,0} - \varepsilon$ ergibt sich dann

$$n = \frac{I_0 \left( \Delta_{mess} - \Delta_{ref} \right)}{I_\Delta \left( 2\varepsilon + \Delta_{mess} + \Delta_{ref} \right)}. \qquad \text{(Gleichung 1')}.$$

Die Restkopplung $\varepsilon$ lässt sich beliebig wählen, insbesondere also auch beliebig klein. Damit lässt sich die Änderung des Regelwerts n für vorgegebene Änderungen $\Delta_{mess}$, $\Delta_{ref}$ der Kapazitäten des Messkondensators 110 und des Referenzkondensators 120 beliebig vorgeben, insbesondere also auch beliebig groß. Dies bedeutet, dass auch kleine Kapazitätsänderungen zu einem großen als Messwert dienenden Regelwert n führen.

Bei der Schaltungsanordnung 100 kann vorteilhafterweise eine wirksame Grundkapazität reduziert werden, ohne dabei eine absolute Kapazitätsänderung zu beeinflussen. Die bei der Schaltungsanordnung 100 wirksame Grundkapazität ergibt sich als Summe der Differenzen der Kapazitäten des ersten Kondensators 110 und des vierten Kondensators 140 auf der einen Seite und des zweiten Kondensators 120 und des dritten Kondensators 130 auf der anderen Seite. Durch angepasste Wahl der Kapazitäten der Kompensationskondensatoren 130, 140 kann die wirksame Grundkapazität einen beliebig kleinen Wert annehmen. Eine beispielsweise durch Annäherung eines Objekts an die Schaltungsanordnung 100 bewirkte absolute Kapazitätsänderung ist jedoch nach wie vor proportional zu den Absolutwerten der Kapazitäten der Kondensatoren 110, 120. Da die Kapazitäten dieser Kondensatoren 110, 120 beliebig große Werte annehmen können, ohne die wirksame Grundkapazität zu beeinflussen, lassen sich ohne großen Aufwand hinreichend große Werte für durch einen Objekteinfluss sich ergebende Kapazitätsänderungen realisieren.

Anstelle der Kompensations-Kondensatoren 130, 140 könnte die Schaltungsanordnung 100 auch beliebige komplexe Impedanzen aufweisen, die beispielsweise als LCR-Netzwerke aufgebaut sein können.

In einer vereinfachten Ausführungsform der Schaltungsanordnung 100 hängt lediglich eines der durch den Regelwerterzeuger 230 erzeugten Steuersignale $I_1$, $I_2$ vom Regelwert n ab. Dann gilt also $I_1 = I_0 + nI_\Delta; I_2 = I_0 + const$ oder $I_1 = I_0 + const; I_2 = I_0 - nI_\Delta$.

Der Messkondensator 110 wird bei einem Balkendetektor mit der Schaltungsanordnung 100 typischerweise als eine oder mehrere Elektroden ausgeführt sein, beispielsweise als metallische Fläche auf einer Leiterplatte. Ebenso können aber auch eine oder mehrere der übrigen Kondensatoren 120, 130, 140 als solche Elektroden ausgeführt sein. Dies kann insbesondere im Hinblick auf die Stabilität des Regelwerts n bei sich ändernden Umweltbedingungen (Temperatur, Luftfeuchte) von Vorteil sein. Dies wird später noch detaillierter ausgeführt.

Das der Schaltungsanordnung 100 zugrunde liegende Prinzip lässt sich wie folgt verallgemeinern. Gemäß Gleichung 1 gehen die vier Kapazitäten $C_{mess}$, $C_{ref}$, $C_{komp,mess}$ und $C_{komp,ref}$ mit jeweils gleicher Gewichtung in den Ausdruck für den Regelwert n ein. Dies gilt, wenn, wie beschrieben, die Pullup-Widerstände 155, 165, 175, 185 alle den gleichen Wert $R_P$ aufweisen und für die Ansteuerung der vier Gleichstromquellen 150, 160, 170, 180 jeweils derselbe Offsetwert $I_0$ und derselbe Bereichswert $I_\Delta$ verwendet werden. Lässt man allerdings unterschiedliche Werte für die Pullup-Widerstände 155, 165, 175, 185 und für die Offsetwerte $I_0$ und die Bereichswerte $I_\Delta$ zu, so ist Gleichung 1 um Gewichtsfaktoren vor den Kapazitäten zu erweitern. Man erhält dann

$$n = \frac{I_0 \left(\left[\alpha_{mess}C_{mess} - \alpha_{komp,mess}C_{komp,mess}\right] - \left[\alpha_{ref}C_{ref} - \alpha_{komp,ref}C_{komp,ref}\right]\right)}{I_\Delta \left(\left[\alpha'_{mess}C_{mess} - \alpha'_{komp,mess}C_{komp,mess}\right] + \left[\alpha'_{ref}C_{ref} - \alpha'_{komp,ref}C_{komp,ref}\right]\right)}.$$

(Gleichung 2).

Im Allgemeinen gilt $\alpha_X = \alpha'_X$. Die Werte der gestrichenen und der ungestrichenen Vorfaktoren unterscheiden sich nur, wenn sowohl die Offsetwerte $I_0$ als auch die Bereichswerte $I_\Delta$ unabhängig voneinander variiert werden.

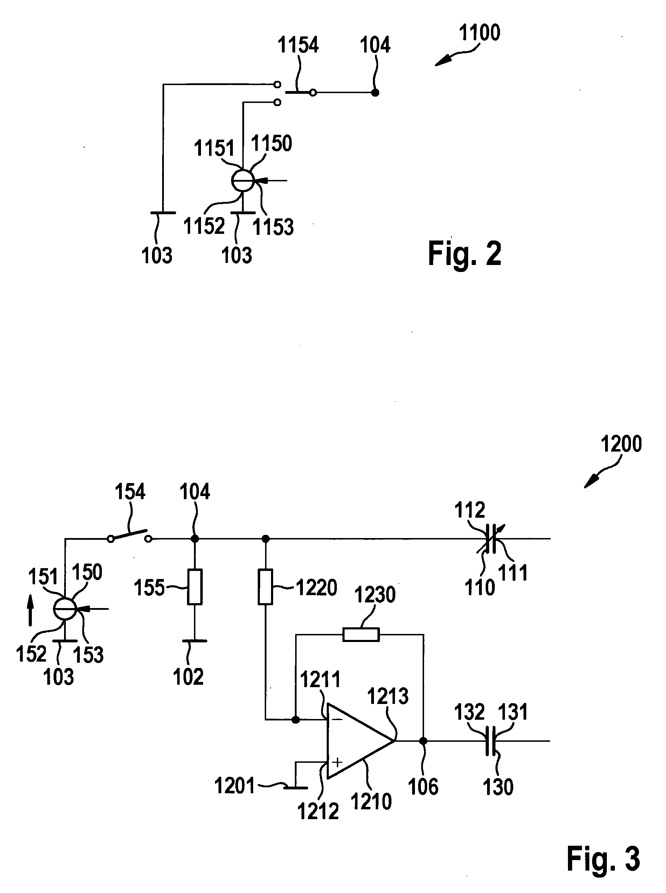

Anhand der Figuren 2, 3 und 4 werden nachfolgend weitere Varianten der Schaltungsanordnung 100 der Fig. 1 erläutert. Dabei sind in Figuren 2 und 3 nur die Teile der Schaltungsanordnungen dargestellt, die sich von der Schaltungsanordnung 100 der Fig. 1 unterscheiden. In allen Figuren 2, 3 und 4 werden für Komponenten, die Komponenten der Schaltungsanordnung 100 der Fig. 1 entsprechen, dieselben Bezugzeichen verwendet.

Fig. 2 zeigt einen Ausschnitt einer Schaltungsanordnung 1100. Bei dieser Schaltungsanordnung 1100 entfallen gegenüber der Schaltungsanordnung 100 der Fig. 1 die erste Gleichstromquelle 150, der erste Schalter 154 und der erste Pullup-Widerstand 155. Stattdessen weist die Schaltungsanordnung 1100 eine erste Gleichspannungsquelle 1150 mit einem ersten Kontakt 1151, einem zweiten Kontakt 1152 und einem Steuerkontakt 1153 auf. Außerdem weist die Schaltungsanordnung 1100 einen weiteren Schalter 1154 auf. Der zweite Kontakt 1152 der ersten Gleichspannungsquelle 1150 ist mit dem Massekontakt 103 verbunden. Der weitere Schalter 1154 der Schaltungsanordnung 1100 dient dazu, den vierten Schaltungsknoten 104 entweder mit dem ersten Kontakt 1154 der ersten Gleichspannungsquelle 1150 oder mit dem Massekontakt 103 zu verbinden. Der Steuerkontakt 1153 der ersten Gleichspannungsquelle 1150 ist mit dem ersten Steuersignalausgang 232 des Regelwerterzeugers 230 verbunden. Der weitere Schalter 1154 wird synchron zum über den Taktsignalausgang 191 des Taktgenerators 190 ausgegebenen Taktsignal geschaltet.

Somit sind bei der Schaltungsanordnung 1100 der Fig. 2 gegenüber der Schaltungsanordnung 100 der Fig. 1 die erste Gleichstromquelle 150 und der erste Pullup-Widerstand 155 durch die erste Gleichspannungsquelle 1150 ersetzt. Die erste Gleichspannungsquelle 1150 erzeugt direkt eine zeitabhängige Gleichspannung mit einstellbarer Amplitude, die in Bezug auf den ersten Schaltungsknoten 101 über den ersten Kondensator 110 angelegt wird. Die übrigen Gleichspannungsquellen 160, 170, 180 und Pullup-Widerstände 165, 175, 185 der Schaltungsanordnung 100 können bei der Schaltungsanordnung 1100 der Fig. 2 entsprechend durch Gleichspannungsquellen ersetzt sein. Gleichung 2 behält bei der Schaltungsanordnung 1100 ihre Gültigkeit, wenn unterschiedliche Offsetwerte $I_0$ und Bereichswerte $I_\Delta$ für die einzelnen Gleichspannungsquellen zugelassen werden.

Fig. 3 zeigt einen Ausschnitt einer weiteren Schaltungsanordnung 1200. Bei der Schaltungsanordnung 1200 entfallen gegenüber der Schaltungsanordnung 100 der Fig. 1 die dritte Gleichspannungsquelle 170, der dritte Schalter 174 und der dritte Pullup-Widerstand 175. Stattdessen weist die Schaltungsanordnung 1200 einen invertierenden Verstärker 1210 mit einem invertierenden Eingang 1211, einem nicht-invertierenden Eingang 1212 und einem Ausgang 1213 auf. Der invertierende Eingang 1211 des invertierenden Verstärkers 1210 ist über einen ersten Widerstand 1220 mit dem vierten Schaltungsknoten 104 verbunden. Der Ausgang 1213 des invertierenden Verstärkers 1210 ist über den zweiten Widerstand 1211 verbunden. Außerdem ist der Ausgang 1213 des invertierenden Verstärkers 1210 mit dem sechsten Schaltungsknoten 106 verbunden. Der nichtinvertierende Eingang 1212 des invertierenden Verstärkers 1210 ist mit einem dritten Schaltungsknoten 1201 verbunden. Der dritte Schaltungsknoten 1201 liegt auf einem konstanten elektrischen Potential, das mittig zwischen dem Potential des zweiten Schaltungsknotens 102 und dem Potential des Massekontakts 103 liegt. Zwischen dem dritten Schaltungsknoten 1201 und dem Massekontakt 103 liegt also eine Spannung Vcc/2 an.

Bei der Schaltungsanordnung 1200 wird die an den dritten Kondensator 130 angelegte Spannung also nicht mittels der dritten Gleichstromquelle 170 und des dritten Pullup-Widerstands 175 erzeugt, sondern mittels des invertierenden Verstärkers 1210 aus dem durch die erste Gleichstromquelle 150 erzeugten Strom. Entsprechend könnte auch die an den vierten Kondensator 140 angelegte Spannung aus dem durch die zweite Gleichstromquelle 160 erzeugten Strom erzeugt werden. Auch könnten umgekehrt die an den ersten Kondensator 110 angelegte Spannung aus dem Strom der dritten Gleichstromquelle 170 und/oder die an den zweiten Kondensator 120 angelegte Spannung aus dem Strom der vierten Gleichstromquelle 180 erzeugt werden.

Werden für den invertierenden Verstärker 1210 und den weiteren invertierenden Verstärker der Schaltungsanordnung 1200 Verstärkungsfaktoren ungleich 1 gewählt, so ergibt sich für den Regelwert n ebenfalls ein Ausdruck gemäß Gleichung 2 mit Gewichtsfaktoren vor den Werten der Kapazitäten der Kondensatoren 110, 120, 130, 140. Die Gewichtsfaktoren resultieren in diesem Fall aus den Verstärkungsfaktoren der invertierenden Verstärker 1210.

Die anhand der Schaltungsanordnung 1200 der Fig. 3 gezeigte Verallgemeinerung hat den Vorteil, dass sich die Flexibilität in der Wahl der Kapazitätswerte der Kondensatoren 110, 120, 130, 140 erhöht. Falls beispielsweise die Kapazitätswerte für den Referenz-Kondensator 120 oder die Kompensations-Kondensatoren 130, 140 sehr klein ausfallen müssen (weil beispielsweise eine Kapazität einer Messelektrode klein ist), so können für diese Kondensatorkapazitäten Gewichtsfaktoren <1 gewählt werden. Dann können Kondensatoren mit größerer Kapazität verwendet werden, die in feinerer Abstufung und mit geringeren Toleranzen erhältlich sind.

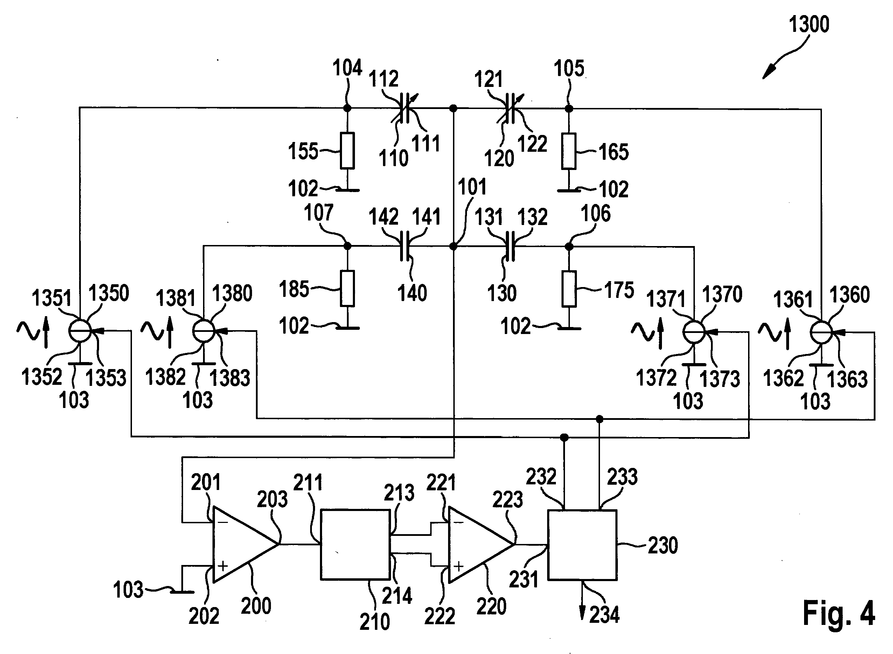

Fig. 4 zeigt eine schematische Darstellung einer weiteren Schaltungsanordnung 1300. Bei der Schaltungsanordnung 1300 entfallen gegenüber der Schaltungsanordnung 100 der Fig. 1 die Gleichstromquellen 150, 160, 170, 180 und die Schalter 154, 164, 174, 184. Stattdessen sind eine erste regelbare Wechselstromquelle 1350, eine zweite regelbare Wechselstromquelle 1360, eine dritte regelbare Wechselstromquelle 1370 und eine vierte regelbare Wechselstromquelle 1380 vorgesehen. Die erste Wechselstromquelle 1350 weist einen ersten Kontakt 1351, einen zweiten Kontakt 1352 und einen Steuerkontakt 1353 auf. Die zweite Wechselstromquelle 1360 weist einen Kontakt 1361, einen zweiten Kontakt 1362 und einen Steuerkontakt 1363 auf. Die dritte Wechselstromquelle 1370 weist einen ersten Kontakt 1371, einen zweiten Kontakt 1372 und einen Steuerkontakt 1373 auf. Die vierte Wechselstromquelle 1380 weist einen ersten Kontakt 1381, einen zweiten Kontakt 1382 und einen Steuerkontakt 1383 auf. Die zweiten Kontakte 1352, 1362, 1372, 1382 der Wechselstromquellen 1350, 1360, 1370, 1380 sind jeweils mit dem Massekontakt 103 verbunden. Der Steuerkontakt 1353 der ersten Wechselstromquelle 1350 und der Steuerkontakt 1373 der dritten Wechselstromquelle 1370 sind mit dem ersten Steuersignalausgang 232 des Regelwerterzeugers 230 verbunden. Der Steuerkontakt 1263 der zweiten Wechselstromquelle 1360 und der Steuerkontakt 1383 der vierten Wechselstromquelle 1380 sind mit dem zweiten Steuersignalausgang 233 des Regelwerterzeugers 230 verbunden.

Der erste Kontakt 1351 der ersten Wechselstromquelle 1350 ist mit dem vierten Schaltungsknoten 104 verbunden. Der erste Kontakt 1361 der zweiten Wechselstromquelle 1360 ist mit dem fünften Schaltungsknoten 105 verbunden. Der erste Kontakt 1371 der dritten Wechselstromquelle 1370 ist mit dem sechsten Schaltungsknoten 106 verbunden. Der erste Kontakt 1381 der vierten Wechselstromquelle 1380 ist mit dem siebten Schaltungsknoten 107 verbunden.

Gegenüber der Schaltungsanordnung 100 der Fig. 1 entfällt bei der Schaltungsanordnung 1300 der Taktgenerator 190. Der Synchrondemodulator 210 wird stattdessen aus einer zum durch die erste Wechselstromquelle 1350 erzeugten Wechselstrom synchronen Quelle angesteuert.

Ein weiterer wesentlicher Vorteil bei den Schaltungsanordnungen 100, 1100, 1200, 1300 der Figuren 1 bis 4 ergibt sich, wenn man die Werte der Pullup-Widerstände 155, 165, 175, 185, die Offsetwerte $I_0$, die Bereichswerte $I_\Delta$ oder die Verstärkungsfaktoren der invertierenden Verstärker 1210 einstellbar ausbildet. Dies ermöglicht es, die Gewichtsfaktoren in Gleichung 2 an die jeweilige Messsituation anzupassen und auf diese Weise beispielsweise die oben eingeführte Restkopplung ε auf einem vorbestimmten Wert zu halten bzw. auf einen geeignet zu bestimmenden Wert einzustellen.

Wird die Schaltungsanordnung 100, 1100, 1200, 1300 in einem kapazitiven Balkendetektor verwendet, so ergibt diese Möglichkeit Sinn, wenn sich die Kapazität eines Messkondensators beispielsweise bei Annäherung des Balkendetektors an eine Wand um einen Wert ändert, der groß gegenüber den typischen Änderungen der Messkapazität durch die zu detektierenden Objekte ist. Damit beeinflusst die Wand die sich durch Objekte ergebende Änderung des Messsignals, weil sie zu einer Änderung (typischerweise einer Erhöhung) der Restkopplung ε führt. Diese Betrachtungsweise geht davon aus, dass die Wand kein Objekt, sondern eine Messumgebung darstellt. Die Änderung der Restkopplung ε hängt von Eigenschaften der Wand ab, beispielsweise von der Dicke, dem Material und der Feuchte der Wand.

Mit der beschriebenen Möglichkeit, die Restkopplung ε einzustellen, kann man nach dem Aufsetzen des Balkendetektors auf der Wand die Restkopplung ε auf einen vorgegebenen Wert einstellen. Auf diese Weise wird der Einfluss der Wand auf den Balkendetektor ausgeglichen und die zu detektierenden Objekte ergeben eine Änderung des Messsignals (des Regelwerts n), die im Wesentlichen unabhängig von der Wand ist.

Derselbe Vorteil lässt sich erzielen, wenn man die Kapazitäten des Referenz-Kondensators 120 oder die Kapazitäten der Kompensations-Kondensatoren 130, 140 einstellbar macht.

Verschwindet die Restkopplung ε, so divergiert ohne zu detektierendes Objekt der Regelwert n gemäß Gleichung 1'. Dies äußert sich in der Praxis darin, dass mit abnehmender Restkopplung ε ein Rauschen des Regelwerts n zunimmt, bis im Falle verschwindender Restkopplung ε die durch die Schaltungsanordnung 100, 1100, 1200, 1300 durchgeführte Regelung versagt und der Regelwert n floatet. Es ist daher vorteilhaft, die Restkopplung ε über das Rauschen festzulegen. So kann beispielsweise die Restkopplung ε über die Variation der Gewichtsfaktoren der Kompensationskapazitäten so lange geändert werden, bis das Rauschen einen bestimmten Wert annimmt. Konkret kann das Rauschen beispielsweise als Standardabweichung einer endlichen Folge von Messwerten bestimmt werden. Ist die Standardabweichung größer als der vorgegebene Wert, so wird die Restkopplung ε erhöht. Ist die Standardabweichung kleiner als der vorgegebene Wert, so wird Restkopplung ε verringert. Dies kann auch iterativ erfolgen.

Die weitere Verarbeitung des Regelwerts n kann insbesondere mit einem Mikrocontroller oder einem Mikroprozessor erfolgen.

Die Schaltungsanordnungen 100, 1100, 1200, 1300 der Figuren 1 bis 4 können in kapazitiven Detektoren, insbesondere in kapazitiven Balkendetektoren verwendet werden. Nachfolgend werden erdfreie kapazitive Balkendetektoren erläutert, die Schaltungsanordnungen der vorgenannten Art aufweisen.

Erdfreie Balkendetektoren weisen mindestens zwei Elektroden auf, wobei an eine der beiden Elektroden ein Anregungssignal angelegt wird (Sendeelektrode) und an der zweiten Elektrode ein Strom oder eine Spannung gemessen wird (Empfangselektrode). Wie in der gesamten Anmeldung werden mit dem Begriff Elektroden Kondensatorbeläge bezeichnet, die als leitfähige Flächen ausgebildet sind, beispielsweise als metallische Flächen auf einer Leiterplatte.

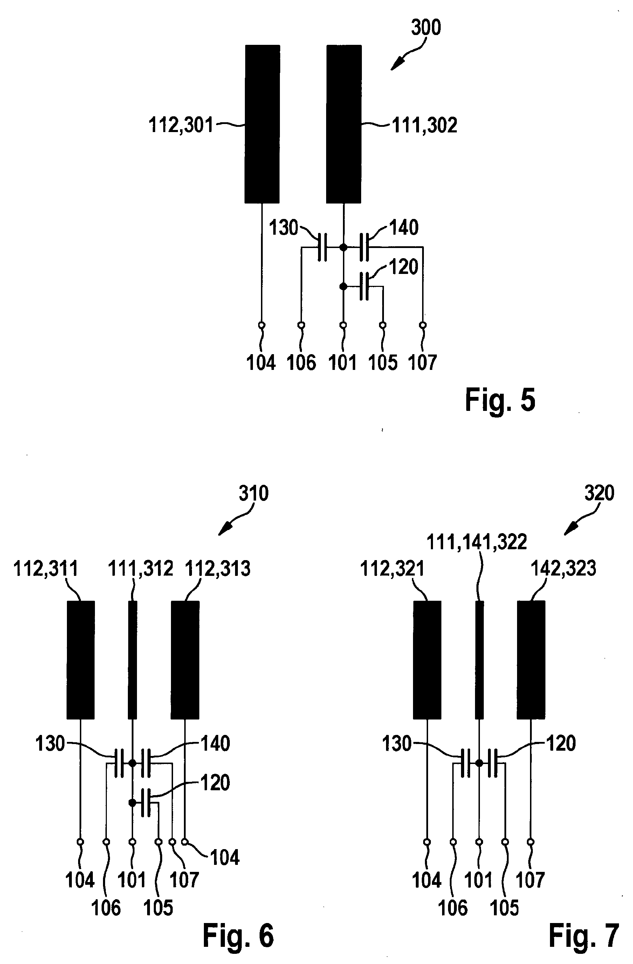

Fig. 5 zeigt in schematischer Darstellung einen prototypischen ersten Balkendetektor 300. Der erste Balkendetektor 300 weist eine erste Elektrode 301 und eine zweite Elektrode 302 auf. Außerdem weist der erste Balkendetektor 300 eine Schaltungsanordnung 100, 1100, 1200, 1300 gemäß einer der Figuren 1 bis 4 auf. Die erste Elektrode 301 bildet den zweiten Kondensatorbelag 112 des ersten Kondensators 110. Die erste Elektrode 301 ist somit mit dem vierten Schaltungsknoten 104 verbunden. Die zweite Elektrode 302 bildet den ersten Kondensatorbelag 111 des ersten Kondensators 110. Die zweite Elektrode 302 ist somit mit dem ersten Schaltungsknoten 101 der Schaltungsanordnung 100 verbunden. Der zweite Kondensator 120, der dritte Kondensator 130 und der vierte Kondensator 140 sind als Festwertkondensatoren ausgebildet.

Die Form, Größe und relative Positionierung der beiden Elektroden 301, 302 folgen dem konkreten Anwendungsfall des ersten Balkendetektors 300.

Wird der erste Balkendetektor 300 an ein Objekt angenähert, so ändert sich die Kapazität des durch die Elektroden 301, 302 gebildeten ersten Kondensators 110, was durch die Schaltungsanordnung 100, 1100, 1200, 1300 durch einen Vergleich mit der konstanten Referenzkapazität des Kondensators 120 ermittelt werden kann. Diese Art der Messung kann als absolute Messung bezeichnet werden.

Da beim ersten Balkendetektor 300 die Kapazität des zweiten Kondensators 120 konstant ist, ist es möglich, auf den vierten Kondensator 140 zu verzichten. Der zweite Kondensator 120 muss dann eine Kapazität $C_{ref}$ aufweisen, deren Größe der Differenz der Kapazitäten $C_{mess}$ des ersten Kondensators 110 und der Kapazität $C_{komp,mess}$ des dritten Kondensators 130 entspricht.

Ein Balkendetektor kann auch mehr als eine Sendeelektrode aufweisen. Balkendetektoren mit mehreren Sendeelektroden werden nachfolgend anhand der Figuren 6 bis 9, 11 bis 14, 19, 20 und 23 bis 25 erläutert. Diese Balkendetektoren weisen stets zumindest eine erste Elektrode, eine zweite Elektrode und eine dritte Elektrode auf. Die zweite Elektrode ist dabei stets zwischen der ersten Elektrode und der dritten Elektrode angeordnet. Die erste Elektrode bildet stets den zweiten Kondensatorbelag 112 des ersten Kondensators 110. Die zweite Elektrode bildet stets die Empfangselektrode, die mit dem ersten Schaltungsknoten 101 verbunden ist.

Fig. 6 zeigt eine schematische Darstellung eines zweiten Balkendetektors 310. Der zweite Balkendetektor 310 weist eine erste Elektrode 311, eine zweite Elektrode 312 und eine dritte Elektrode 313 auf. Die erste Elektrode 311 und die dritte Elektrode 313 bilden gemeinsam den zweiten Kondensatorbelag 112 des ersten Kondensators 110. Die zweite Elektrode 311 bildet den ersten Kondensatorbelag 111 des ersten Kondensators 110. Der zweite Kondensator 120, der dritte Kondensator 130 und der vierte Kondensator 140 sind als Festwertkondensatoren ausgebildet. Der zweite Balkendetektor 310 der Fig. 6 weist vorteilhafterweise eine symmetrische Ausgestaltung auf.

Fig. 7 zeigt eine schematische Darstellung eines dritten Balkendetektors 320. Der dritte Balkendetektor 320 weist eine erste Elektrode 321, eine zweite Elektrode 322 und eine dritte Elektrode 323 auf. Die erste Elektrode 321 bildet den zweiten Kondensatorbelag 112 des ersten Kondensators 110. Die dritte Elektrode 323 bildet den zweiten Kondensatorbelag 142 des vierten Kondensators 140.

Die zweite Elektrode 322 bildet den ersten Kondensatorbelag 111 des ersten Kondensators 110 und den ersten Kondensatorbelag 141 des vierten Kondensators 140. Der zweite Kondensator 120 und der dritte Kondensator 130 sind als Festwertkondensatoren ausgebildet.

Beim dritten Balkendetektor 320 ändert sich bei Annäherung des dritten Balkendetektors 320 an ein Objekt nicht nur die Kapazität $C_{mess}$ des ersten Kondensators 110, sondern auch die Kapazität $C_{komp,ref}$ des vierten Kondensators 140. Beim dritten Balkendetektor 320 ist die Kapazität $C_{ref}$ des zweiten Kondensators 120 daher so groß zu wählen, dass die Kapazität $C_{komp,ref}$ des vierten Kondensators in allen regulären Anwendungsfällen des dritten Balkendetektors 320 kleiner als die Kapazität $C_{ref}$ des zweiten Kondensators 120 ist.

Die Kapazitäten $C_{mess}$ des ersten Kondensators 110 und $C_{komp,ref}$ des vierten Kondensators 140 sind variabel mit fixem Anteil $C_{mess,0}$, $C_{komp,ref,0}$ und variablen Anteilen $\Delta_{mess}$ und $\Delta_{komp,ref}$. Durch die Wahl $C_{komp,mess} = C_{mess,0} - \varepsilon$ und $C_{ref} = C_{komp,ref,0} + \varepsilon$ ergibt sich dann

$$n = \frac{I_0 \left( \Delta_{mess} + \Delta_{komp,ref} \right)}{I_\Delta \left( 2\varepsilon + \Delta_{mess} - \Delta_{komp,ref} \right)}.$$

Wenn $\Delta_{mess}$ gleich $\Delta_{komp,ref}$ ist, so ist der Regelwert n vorteilhafterweise linear. Außerdem ist die Empfindlichkeit des dritten Balkendetektors 320 dann vorteilhafterweise von der Größe des Regelwerts n, also von der Größe des Messwerts, unabhängig.

Wählt man beim dritten Balkendetektor 320 das Steuersignal $I_1$ konstant und regelt lediglich das zweite Steuersignal $I_2$, so ist der Regelwert n gegeben durch

$$n = \frac{I_0 \left( \Delta_{mess} + \Delta_{komp,mess} \right)}{I_\Delta \left( \varepsilon - \Delta_{komp,ref} \right)}.$$

Wählt man dagegen das zweite Steuersignal $I_2$ konstant und regelt lediglich das erste Steuersignal $I_1$, so ergibt sich der Regelwert n zu

$$n = \frac{I_0 \left( \Delta_{mess} + \Delta_{komp,mess} \right)}{I_\Delta \left( \varepsilon + \Delta_{mess} \right)}.$$

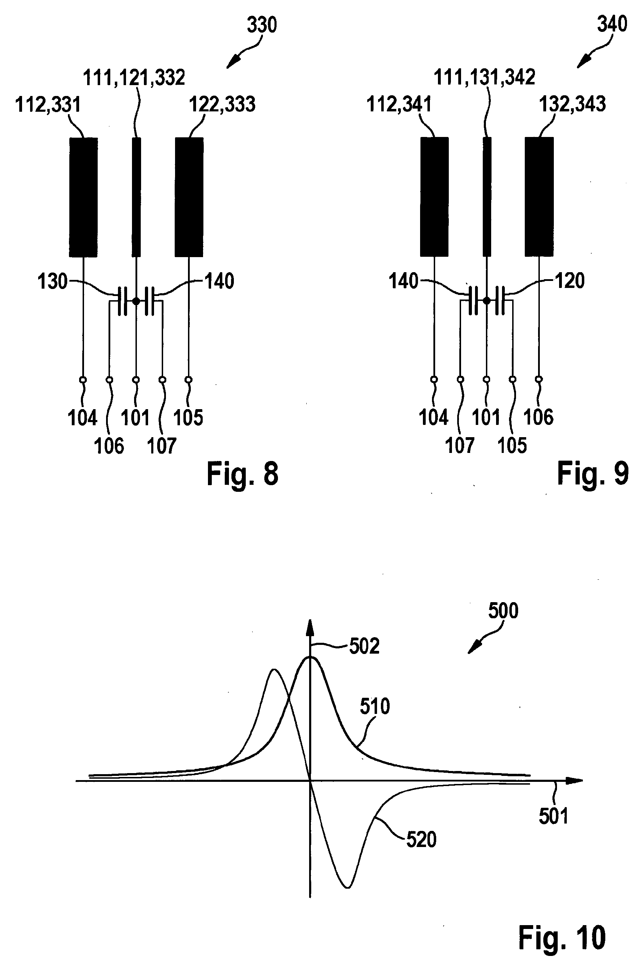

Fig. 8 zeigt eine schematische Darstellung eines vierten Balkendetektors 330. Der vierte Balkendetektor 330 weist eine erste Elektrode 331, eine zweite Elektrode 332 und eine dritte Elektrode 333 auf. Die erste Elektrode 331 bildet den zweiten Kondensatorbelag 112 des ersten Kondensators 110. Die dritte Elektrode 333 bildet den zweiten Kondensatorbelag 122 des zweiten Kondensators 120. Die zweite Elektrode 332 bildet den ersten Kondensatorbelag 111 des ersten Kondensators 110 und den ersten Kondensatorbelag 121 des zweiten Kondensators 120. Der dritte Kondensator 130 und der vierte Kondensator 140 sind als Festwertkondensatoren ausgebildet.

Beim vierten Balkendetektor 330 sind somit die Kapazitäten $C_{mess}$ des ersten Kondensators 110 und $C_{ref}$ des zweiten Kondensators 120 variabel. Der Regelwert n ist gegeben durch

$$n = \frac{I_0 \left( \Delta_{mess} - \Delta_{ref} \right)}{I_\Delta \left( 2\varepsilon + \Delta_{mess} + \Delta_{ref} \right)}.$$

Fig. 9 zeigt eine schematische Darstellung eines fünften Balkendetektors 340. Die erste Elektrode 341 des fünften Balkendetektors 340 bildet den zweiten Kondensatorbelag 112 des ersten Kondensators 110. Eine dritte Elektrode 343 des fünften Balkendetektors 340 bildet den zweiten Kondensatorbelag 132 des dritten Kondensators 130. Eine zweite Elektrode 342 des fünften Balkendetektors 340 bildet den ersten Kondensatorbelag 111 des ersten Kondensators 110 und den ersten Kondensatorbelag 131 des dritten Kondensators 130. Der zweite Kondensator 120 und der vierte Kondensator 140 sind als Festwertkondensatoren ausgebildet.

Beim fünften Balkendetektor 340 sind somit die Kapazitäten $C_{mess}$ des ersten Kondensators 110 und $C_{komp,mess}$ des dritten Kondensators 130 variabel. Gilt aus Symmetriegründen, dass die Kopplungen der beiden Sendeelektroden 341, 343 zur Empfangselektrode 342 gleich groß sind, so kann durch eine zusätzliche, konstante Kapazität am vierten Schaltungsknoten 104 sichergestellt werden, dass $C_{mess}$, größer als $C_{komp,mess}$ ist. Die Differenz der Kapazität $C_{ref}$ des zweiten Kondensators 120 und der Kapazität $C_{komp,ref}$ des vierten Kondensators 140 wird dann in der Größe dieser zusätzlichen konstanten Kapazität gewählt. Der Regelwert n ergibt sich dann zu

$$n = \frac{I_0\left(\Delta_{mess} - \Delta_{komp,mess}\right)}{I_\Delta\left(2\varepsilon + \Delta_{mess} - \Delta_{komp,mess}\right)}.$$

Wählt man das erste Steuersignal $I_1$ konstant und regelt nur das zweite Steuersignal $I_2$, so ist der Regelwert n gegeben durch

$$n = \frac{I_0\left(\Delta_{mess} - \Delta_{komp,mess}\right)}{I_\Delta\varepsilon}.$$

Bei dem ersten Balkendetektor 300, dem zweiten Balkendetektor 310, dem dritten Balkendetektor 320, dem vierten Balkendetektor 330 und dem fünften Balkendetektor 340 können die als Festwertkondensatoren ausgebildeten Kondensatoren auch durch Elektrodenpaare gebildet werden. Wesentlich ist dabei nur, dass die Kapazität dieser Festwertkondensatoren nicht von Objekten oder der Messumgebung beeinflusst wird oder dieser Einfluss sehr klein gegenüber dem Einfluss auf die variablen Kapazitäten der Balkendetektoren 300, 310, 320, 330, 340 ist.

Der erste Balkendetektor 300 der Fig. 5, der zweite Balkendetektor 310 der Fig. 6, und der dritte Balkendetektor 320 der Fig. 7 eignen sich zum Durchführen absoluter Messungen. Der vierte Balkendetektor 330 der Fig. 8 und der fünfte Balkendetektor 340 der Fig. 9 eignen sich zum Durchführen differenzieller Messungen. Fig. 10 zeigt einen schematischen Messwertverlauf 500 zur Erläuterung des Unterschieds dieser Messprinzipien. Auf einer horizontalen Achse des Graphen der Fig. 10 ist eine Ortskoordinate 501 aufgetragen. Auf einer vertikalen Achse 502 des Graphen ist der Regelwert n dargestellt. Die Ortskoordinate 501 entspricht der Raumrichtung, in der die Elektroden der Balkendetektoren 300, 310, 320, 330, 340 nebeneinander angeordnet sind. Wird ein Objekt in Richtung der Ortskoordinate 501 unter den Balkendetektoren 300, 310, 320, 330, 340 hindurchbewegt, so ergeben sich beim ersten Balkendetektor 300, beim zweiten Balkendetektor 310 und beim dritten Balkendetektor 320 der Verlauf des Regelwerts n gemäß der absoluten Messung 510. Beim vierten Balkendetektor 330 und beim fünften Balkendetektor 340 ergibt sich der Verlauf des Regelwerts n gemäß der differenziellen Messung 520.

Die Abhängigkeit des Regelwerts n von Kapazitätsänderungen der Kondensatoren 110, 120, 130, 140 stellt sich wie folgt dar: Erhöht sich die kapazitive Kopplung zwischen dem ersten Kondensatorbelag 111 und dem zweiten Kondensatorbelag 112 des ersten Kondensators 110, so fließt mehr Strom in der ersten Phase und der Regelwert n nimmt ab. Erhöht sich die kapazitive Kopplung zwischen dem ersten Kondensatorbelag 121 und dem zweiten Kondensatorbelag 122 des zweiten Kondensators 120, so fließt mehr Strom während der zweiten Phase und der Regelwert n nimmt zu. Erhöht sich die kapazitive Kopplung zwischen dem ersten Kondensatorbelag 131 und dem zweiten Kondensatorbelag 132 des dritten Kondensators 130, so fließt weniger Strom während der ersten Phase und der Regelwert n nimmt zu. Erhöht sich die kapazitive Kopplung zwischen dem ersten Kondensatorbelag 141 und dem zweiten Kondensatorbelag 142 des vierten Kondensators 140, so fließt weniger Strom während der zweiten Phase und der Regelwert n nimmt ab.

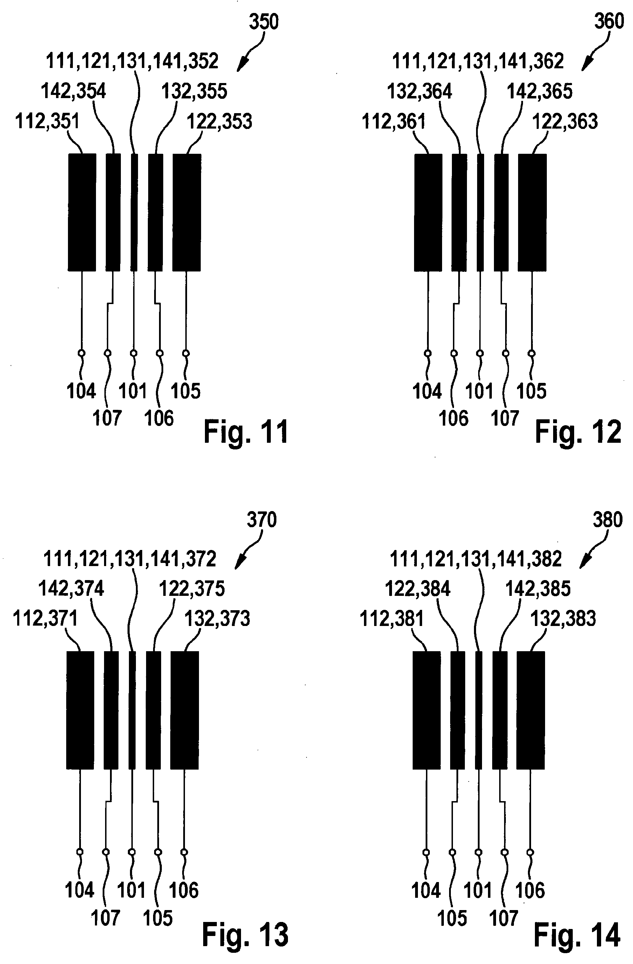

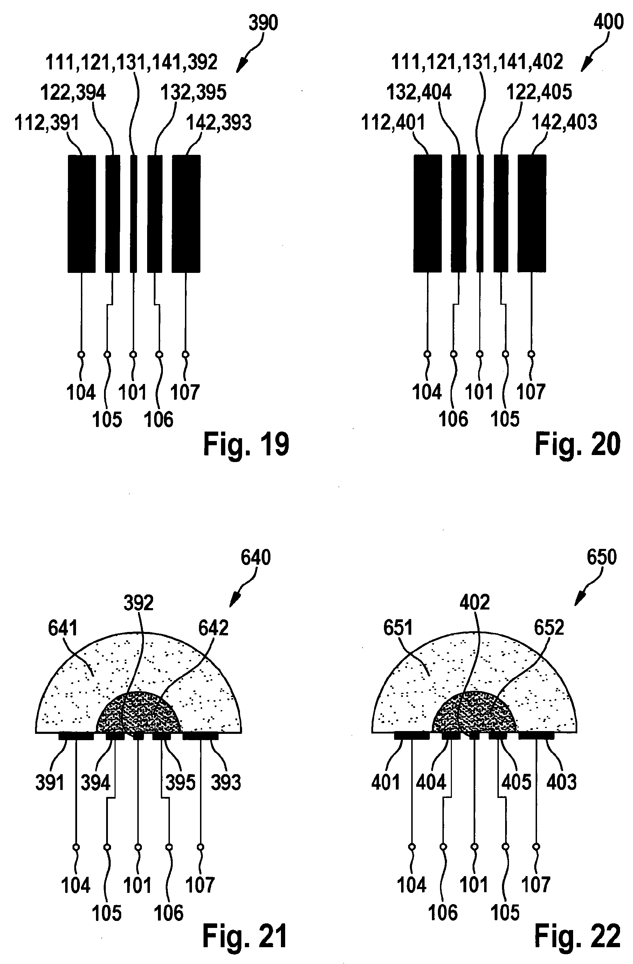

Figuren 11 bis 14 zeigen weitere Beispiele von Balkendetektoren, die sich zum Durchführen differenzieller Messungen eignen. Figuren 19, 20, 23, 24 und 25 zeigen weitere Beispiele von Balkendetektoren, die sich zum Durchführen absoluter Messungen eignen. Alle diese Balkendetektoren weisen insgesamt fünf Elektroden auf. Dabei gilt weiterhin, dass die zweite Elektrode zwischen der ersten Elektrode und der dritten Elektrode angeordnet ist. Zusätzlich ist bei diesen Balkendetektoren die vierte Elektrode zwischen der ersten Elektrode und der zweiten Elektrode angeordnet. Die fünfte Elektrode ist zwischen der zweiten Elektrode und der dritten Elektrode angeordnet.

Fig. 11 zeigt eine schematische Darstellung eines sechsten Balkendetektors 350. Eine erste Elektrode 351 bildet den zweiten Kondensatorbelag 112 des ersten Kondensators 110. Eine vierte Elektrode 354 bildet den zweiten Kondensatorbelag 142 des vierten Kondensators 140. Eine fünfte Elektrode 355 bildet den zweiten Kondensatorbelag 132 des dritten Kondensators 130. Eine dritte Elektrode 353 bildet den zweiten Kondensatorbelag 122 des zweiten Kondensators 120. Eine zweite Elektrode 352 bildet den ersten Kondensatorbelag 111 des ersten Kondensators 110, den ersten Kondensatorbelag 121 des zweiten Kondensators 120, den ersten Kondensatorbelag 131 des dritten Kondensators 130 und den ersten Kondensatorbelag 141 des vierten Kondensators 140.

Fig. 12 zeigt eine schematische Darstellung eines siebten Balkendetektors 360. Eine erste Elektrode 361 bildet den zweiten Kondensatorbelag 112 des ersten Kondensators 110. Eine vierte Elektrode 364 bildet den zweiten Kondensatorbelag 132 des dritten Kondensators 130. Eine fünfte Elektrode 365 bildet den zweiten Kondensatorbelag 142 des vierten Kondensators 140. Eine dritte Elektrode 363 bildet den zweiten Kondensatorbelag 122 des zweiten Kondensators 120. Eine zweite Elektrode 362 bildet die ersten Kondensatorbeläge 111, 121, 131, 141 der Kondensatoren 110, 120, 130, 140.

Fig. 13 zeigt eine schematische Darstellung eines achten Balkendetektors 370. Eine erste Elektrode 371 bildet den zweiten Kondensatorbelag 112 des ersten Kondensators 110. Eine vierte Elektrode 374 bildet den zweiten Kondensatorbelag 142 des vierten Kondensators 140. Eine fünfte Elektrode 375 bildet den zweiten Kondensatorbelag 122 des zweiten Kondensators 120. Eine dritte Elektrode 373 bildet den zweiten Kondensatorbelag 132 des dritten Kondensators 130. Eine zweite Elektrode 372 bildet die ersten Kondensatorbeläge 111, 121, 131, 141 der vier Kondensatoren 110, 120, 130, 140.

Fig. 14 zeigt eine schematische Darstellung eines neunten Balkendetektors 380. Eine erste Elektrode 381 bildet den zweiten Kondensatorbelag 112 des ersten Kondensators 110. Eine vierte Elektrode 384 bildet den zweiten Kondensatorbelag 122 des zweiten Kondensators 120. Eine fünfte Elektrode 385 bildet den zweiten Kondensatorbelag 142 des vierten Kondensators 140. Eine dritte Elektrode 383 bildet den zweiten Kondensatorbelag 132 des dritten Kondensators 130. Eine zweite Elektrode 382 bildet die ersten Kondensatorbeläge 111, 121, 131, 141 der vier Kondensatoren 110, 120, 130, 140.

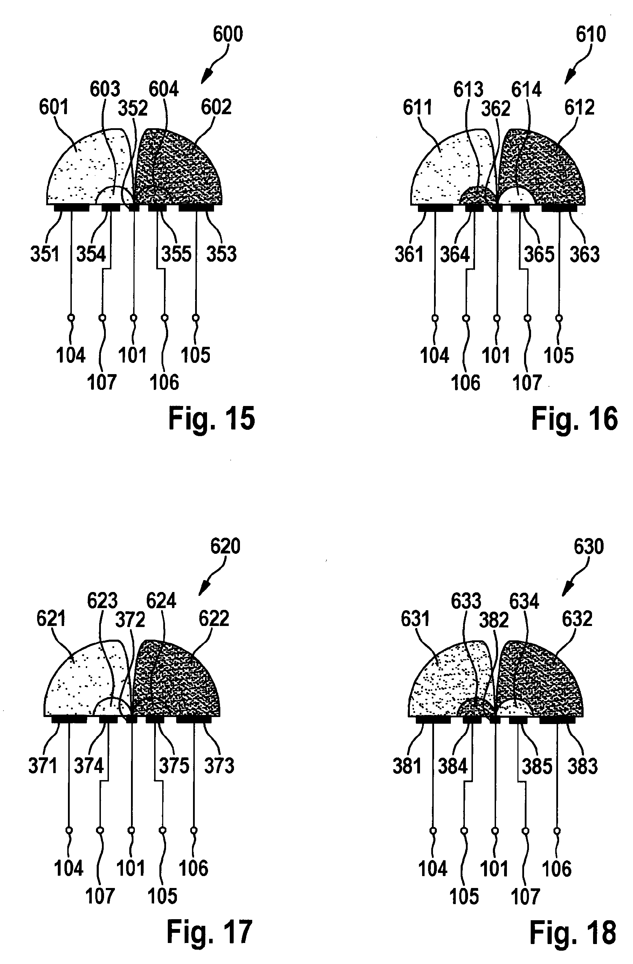

Figuren 15 bis 18 zeigen in schematischer Darstellung die Einflussbereiche der unterschiedlichen Elektroden der Balkendetektoren 350, 360, 370, 380 der Figuren 11 bis 14.

Fig. 15 zeigt ein erstes Messverhalten 600 des sechsten Balkendetektors 350 der Fig. 11. Ein erster Einflussbereich 601 stellt schematisch den Einflussbereich der ersten Elektrode 351 dar. Ein sich im ersten Einflussbereich 601 befindliches Objekt reduziert den Regelwert n. Ein sich in einem zweiten Einflussbereich 602 der dritten Elektrode 353 befindliches Objekt erhöht den Regelwert n. Ein sich in einem dritten Einflussbereich 603 der vierten Elektrode 354 befindliches Objekt reduziert den Regelwert n. Ein sich in einem vierten Einflussbereich 604 der fünften Elektrode 355 des sechsten Balkendetektors 350 befindliches Objekt erhöht den Regelwert n.

Fig. 16 zeigt ein zweites Messverhalten 610 des siebten Balkendetektors 360. Ein sich in einem ersten Einflussbereich 611 der ersten Elektrode 361 befindliches Objekt reduziert den Regelwert n. Ein sich in einem zweiten Einflussbereich 612 der dritten Elektrode 363 befindliches Objekt erhöht den Regelwert n. Ein sich in einem dritten Einflussbereich 613 der vierten Elektrode 364 befindliches Objekt erhöht den Regelwert n ebenfalls. Ein sich in einem vierten Einflussbereich 614 der fünften Elektrode 365 befindliches Objekt reduziert den Regelwert n.

Fig. 17 zeigt in schematischer Darstellung ein drittes Messverhalten 620 des achten Balkendetektors 370. Ein sich in einem ersten Einflussbereich 621 der ersten Elektrode 371 befindliches Objekt reduziert den Regelwert n. Ein sich in einem zweiten Einflussbereich 622 der dritten Elektrode 373 befindliches Objekt erhöht den Regelwert n. Ein sich in einem dritten Einflussbereich 623 der vierten Elektrode 374 befindliches Objekt reduziert den Regelwert n. Ein sich in einem vierten Einflussbereich 624 der fünften Elektrode 375 befindliches Objekt erhöht den Regelwert n.

Fig. 18 zeigt in schematisierter Darstellung ein viertes Messverhalten 630 des neunten Balkendetektors 380 der Fig. 14. Ein sich in einem ersten Einflussbereich 631 der ersten Elektrode 381 befindliches Objekt reduziert den Regelwert n. Ein sich in einem zweiten Einflussbereich 632 der dritten Elektrode 383 befindliches Objekt erhöht den Regelwert n. Ein sich in einem dritten Einflussbereich 633 der vierten Elektrode 384 befindliches Objekt erhöht den Regelwert n ebenfalls. Ein sich in einem vierten Einflussbereich 634 der fünften Elektrode 385 befindliches Objekt reduziert den Regelwert n.

Fig. 19 zeigt in schematischer Darstellung einen zehnten Balkendetektor 390. Eine erste Elektrode 391 bildet den zweiten Kondensatorbelag 112 des ersten Kondensators 110. Eine vierte Elektrode 394 bildet den zweiten Kondensatorbelag 122 des zweiten Kondensators 120. Eine fünfte Elektrode 395 bildet den zweiten Kondensatorbelag 132 des dritten Kondensators 130. Eine dritte Elektrode 393 bildet den zweiten Kondensatorbelag 142 des vierten Kondensators 140. Eine zweite Elektrode 392 bildet die ersten Kondensatorbeläge 111, 121, 131, 141 der vier Kondensatoren 110, 120, 130, 140.

Fig. 20 zeigt in schematischer Darstellung einen elften Balkendetektor 400. Eine erste Elektrode 401 bildet den zweiten Kondensatorbelag 112 des ersten Kondensators 110. Eine vierte Elektrode 404 bildet den zweiten Kondensatorbelag 132 des dritten Kondensators 130. Eine fünfte Elektrode 405 bildet den zweiten Kondensatorbelag 122 des zweiten Kondensators 120. Eine dritte Elektrode 403 bildet den zweiten Kondensatorbelag 142 des vierten Kondensators 140. Eine zweite Elektrode 402 bildet die ersten Kondensatorbeläge 111, 121, 131, 141 der vier Kondensatoren 110, 120, 130, 140.

Fig. 21 zeigt in schematisierter Darstellung ein fünftes Messverhalten 640 des zehnten Balkensensors 390 der Fig. 19. In einem äußeren Einflussbereich 641 der ersten Elektrode 391 und der dritten Elektrode 393 sinkt der Regelwert n bei Eindringen eines Objekts. Gelangt ein Objekt in einen inneren Einflussbereich 642 der vierten Elektrode 394 und der fünften Elektrode 395, so steigt der Regelwert n.

Fig. 22 zeigt ein schematisches sechstes Messverhalten 650 des elften Balkendetektors 400 der Fig. 20. Gelangt ein Objekt in einen äußeren Einflussbereich 651 der ersten Elektrode 401 und der dritten Elektrode 403, so sinkt der Regelwert n. Gelangt ein Objekt in einen inneren Einflussbereich 652 der vierten Elektrode 404 und der fünften Elektrode 405, so steigt der Regelwert n.

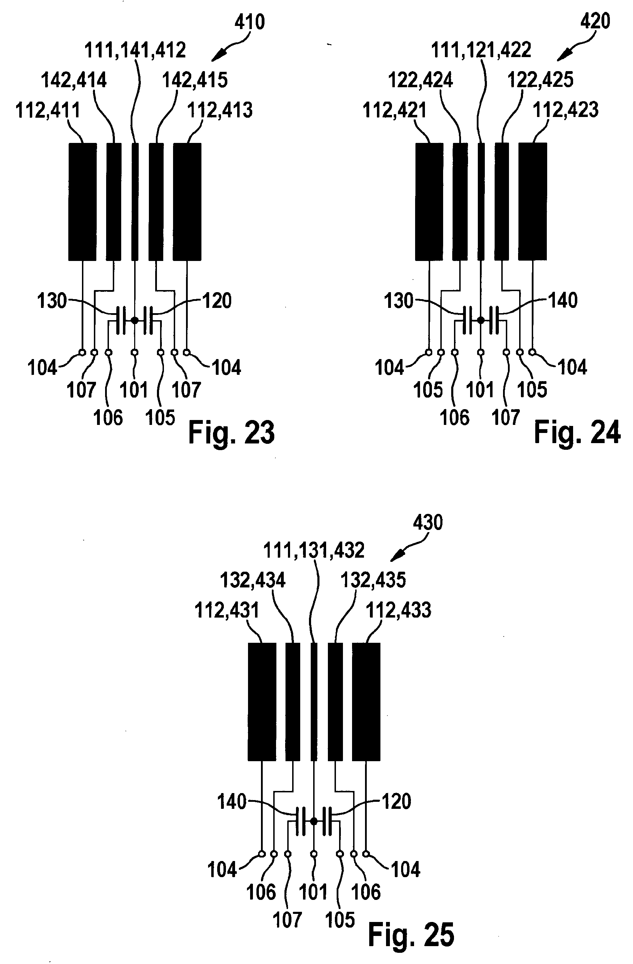

Fig. 23 zeigt eine schematische Darstellung eines zwölften Balkendetektors 410. Eine erste Elektrode 411 und eine dritte Elektrode 413 bilden gemeinsam den zweiten Kondensatorbelag 112 des ersten Kondensators 110. Eine vierte Elektrode 414 und eine fünfte Elektrode 415 bilden gemeinsam den zweiten Kondensatorbelag 142 des vierten Kondensators 140. Eine zweite Elektrode 412 bildet den ersten Kondensatorbelag 111 des ersten Kondensators 110 und den ersten Kondensatorbelag 141 des vierten Kondensators 140. Der zweite Kondensator 120 und der dritte Kondensator 130 sind als Festwertkondensatoren ausgebildet.

Fig. 24 zeigt eine schematische Darstellung eines dreizehnten Balkendetektors 420. Eine erste Elektrode 421 und eine dritte Elektrode 423 bilden gemeinsam den zweiten Kondensatorbelag 112 des ersten Kondensators 110. Eine vierte Elektrode 424 und eine fünfte Elektrode 425 bilden gemeinsam den zweiten Kondensatorbelag 122 des zweiten Kondensators 120. Eine zweite Elektrode 422 bildet den ersten Kondensatorbelag 111 des ersten Kondensators 110 und den ersten Kondensatorbelag 121 des zweiten Kondensators 120. Der dritte Kondensator 130 und der vierte Kondensator 140 sind als Festwertkondensatoren ausgebildet.

Fig. 25 zeigt eine schematische Darstellung eines vierzehnten Balkendetektors 430. Eine erste Elektrode 431 und eine dritte Elektrode 433 bilden gemeinsam den zweiten Kondensatorbelag 112 des ersten Kondensators 110. Eine vierte Elektrode 434 und eine fünfte Elektrode 435 bilden gemeinsam den zweiten Kondensatorbelag 132 des dritten Kondensators 130. Eine zweite Elektrode 432 bildet den ersten Kondensatorbelag 111 des ersten Kondensators 110 und den ersten Kondensatorbelag 131 des dritten Kondensators 130. Der zweite Kondensator 120 und der vierte Kondensator 140 sind als Festwertkondensatoren ausgebildet.

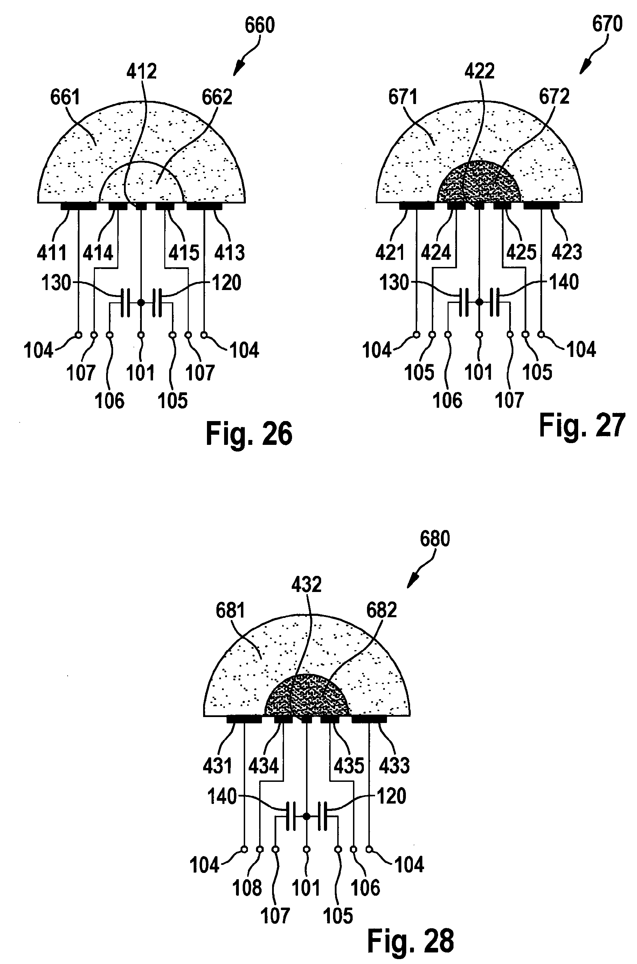

Fig. 26 zeigt in einer schematischen Darstellung ein siebtes Messverhalten 660 des zwölften Balkendetektors 410 der Fig. 23. Gelangt ein Objekt in einen äußeren Einflussbereich 661 der ersten Elektrode 411 und der dritten Elektrode 413, so sinkt der Regelwert n. Gelangt ein Objekt in einen inneren Einflussbereich 662 der vierten Elektrode 414 und der fünften Elektrode 415, so sinkt der Regelwert n ebenfalls.

Fig. 27 zeigt ein schematisches achtes Messverhalten 670 des dreizehnten Balkendetektors 420. Gelangt ein Objekt in einen äußeren Einflussbereich 671 der ersten Elektrode 421 und der dritten Elektrode 423, so sinkt der Regelwert n. Gelangt ein Objekt in einen inneren Einflussbereich 672 der vierten Elektrode 424 und der fünften Elektrode 425, so steigt der Regelwert n.

Fig. 28 zeigt ein schematisches neuntes Messverhalten 680 des vierzehnten Balkendetektors 430 der Fig. 25. Gelangt ein Objekt in einen äußeren Einflussbereich 681 der ersten Elektrode 431 und der dritten Elektrode 433, so sinkt der Regelwert n. Gelangt ein Objekt in einen inneren Einflussbereich 682 der vierten Elektrode 434 und der fünften Elektrode 435, so steigt der Regelwert n.

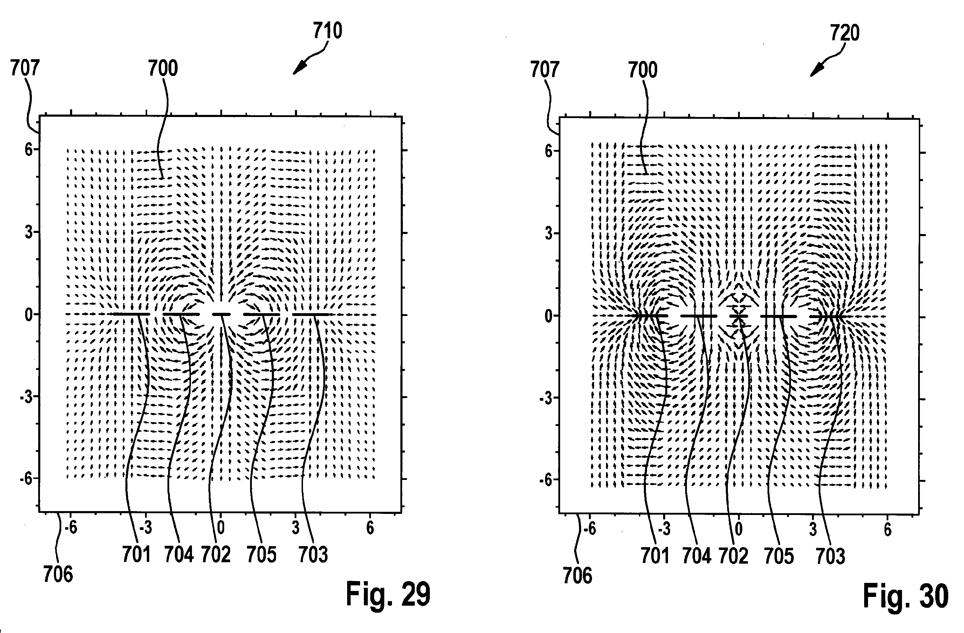

Die in Figuren 11 bis 14, 19, 20 und 23 bis 25 dargestellten Balkendetektoren 350, 360, 370, 380, 390, 400, 410, 420, 430 lassen sich hinsichtlich der an den Elektroden anliegenden Spannungen auf vier Fälle reduzieren. Figuren 29 bis 32 zeigen elektrische Felder 700, die sich in diesen vier Fällen ergeben. Dargestellt ist jeweils eine erste Elektrode 701, eine zweite Elektrode 702, eine dritte Elektrode 703, eine vierte Elektrode 704 und eine fünfte Elektrode 705. Die fünf Elektroden 701, 702, 703, 704, 705 sind entlang einer ersten Raumkoordinate 706 nebeneinander angeordnet, wobei die erste Elektrode 701, die vierte Elektrode 704, die zweite Elektrode 702, die fünfte Elektrode 705 und die dritte Elektrode 703 in dieser Reihenfolge aufeinander folgen. Eine zweite Raumkoordinate 707 ist senkrecht zur ersten Raumkoordinate 706 und senkrecht zur Ebene der Elektroden 701, 702, 703, 704, 705 orientiert.

Eine in Fig. 29 gezeigte erste Potentialverteilung 710 ergibt sich in dem Fall, dass an allen vier Sendeelektroden 701, 704, 705, 703 dasselbe Potential anliegt. Dieser Fall kann als absolute klassische Messung verstanden werden.

Eine in Fig. 30 dargestellte zweite Potentialverteilung 720 ergibt sich in dem Fall, dass an den Sendeelektroden 701, 704 links und den Sendeelektroden 705, 703 rechts der Empfangselektrode 702 jeweils dasselbe Potential anliegt, sich das Vorzeichen zwischen dem linken Paar 701, 704 und dem rechten Paar 705, 703 jedoch unterscheidet. Dieser Fall kann als differenzielle klassische Messung verstanden werden.

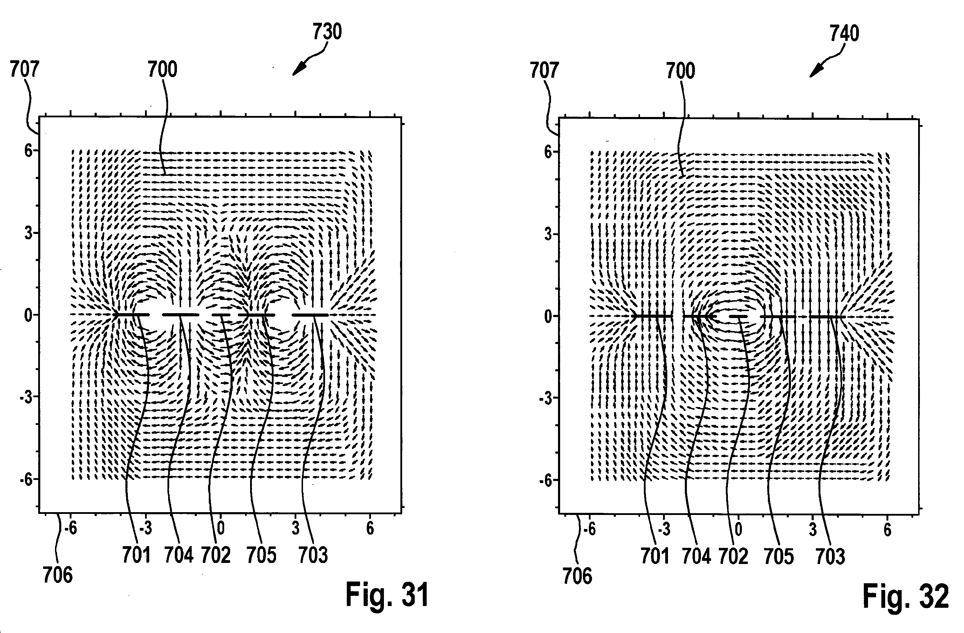

Eine in Fig. 31 dargestellte dritte Potentialverteilung 730 ergibt sich in dem Fall, dass an den äußeren Sendeelektroden 701, 703 und den inneren Sendeelektroden 704, 705 jeweils das gleiche Potential anliegt, sich die Vorzeichen zwischen dem äußeren Paar 701, 703 und dem inneren Paar 704, 705 jedoch unterscheiden. Dieser Fall kann als absolute progressive Messung verstanden werden.

Eine in Fig. 32 dargestellte vierte Potentialverteilung 740 ergibt sich in dem Fall, dass sich die Vorteile der Potentiale sowohl zwischen den Sendeelektroden 701, 704 bzw. 705, 703 auf einer Seite, als auch zwischen den äußeren Sendeelektroden 701, 703 und zwischen den inneren Sendeelektroden 704, 705 unterscheidet. Dieser Fall kann als differenzielle progressive Messung verstanden werden.

Die dritte Potentialverteilung 730 und die vierte Potentialverteilung 740 erlauben eine Abhängigkeit des Vorzeichens der Änderung des Regelwerts n vom Abstand eines Objekts senkrecht zum Balkendetektor. Die dargestellten Verläufe des elektrischen Felds 700 weisen jeweils einen Punkt auf, an dem sich die elektrischen Felder 700 auslöschen. Die Entfernung vom Balkendetektor, in der ein solcher Vorzeichenwechsel der Änderung des Regelwerts n auftritt, lässt sich über die Geometrie der Elektroden und über die an die Elektroden angelegten Spannungen beeinflussen. In der durch den Vorzeichenwechsel charakterisierten Entfernung ist der Balkendetektor blind. In einem kapazitiven Balkendetektor kann diese Eigenschaft vorteilhaft ausgenutzt werden, um den Balkendetektor robuster gegen bestimmte Störungen zu machen. Hierzu zählen Inhomogenitäten des Wandmaterials und ein unbeabsichtigtes Verkippen des Balkendetektors auf der Wandoberfläche, wie es beispielsweise durch eine mangelhafte Handhabung seitens des Benutzers, durch eine raue Wandoberfläche oder aus anderen Gründen auftreten kann. Hierdurch lässt sich die Zuverlässigkeit des Balkendetektors vorteilhafterweise deutlich gegenüber dem Stand der Technik verbessern.

## Patentansprüche

1. Schaltungsanordnung (100, 1100, 1200, 1300)
   mit einem ersten Kondensator (110), einem zweiten Kondensator (120) und einem dritten Kondensator (130), wobei erste Kondensatorbeläge (111, 121, 131) der Kondensatoren (110, 120, 130) jeweils mit einem ersten Schaltungsknoten (101) verbunden sind, wobei die Schaltungsanordnung (100, 1100, 1200, 1300) ausgebildet ist, den ersten Kondensator (110) mit einer ersten zeitabhängigen Spannung zu beaufschlagen, den zweiten Kondensator (120) mit einer zweiten zeitabhängigen Spannung zu beaufschlagen und den dritten Kondensator (130) mit einer dritten zeitabhängigen Spannung zu beaufschlagen,
   wobei die erste Spannung und die zweite Spannung gegenphasig getaktet sind,
   wobei die zweite Spannung und die dritte Spannung gleichphasig getaktet sind,
   wobei die Schaltungsanordnung (100, 1100, 1200, 1300) einen Verstärker (200), einen Synchrondemodulator (210) und einen Komparator (220) umfasst,
   wobei Eingänge (201, 202) des Verstärkers (200) mit dem ersten Schaltungsknoten (101) und mit einem Massekontakt (103) verbunden sind, wobei der Synchrondemodulator (210) dazu vorgesehen ist, ein Ausgangssignal des Verstärkers (200) synchron zum Takt der ersten Spannung abwechselnd an zwei Eingänge (221, 222) des Komparators (220) anzulegen, wobei die Schaltungsanordnung (100, 1100, 1200, 1300) ausgebildet ist, in Abhängigkeit von einem Ausgangswert des Komparators (220) einen Regelwert zu generieren,
   wobei die Schaltungsanordnung (100, 1100, 1200, 1300) ferner ausgebildet ist, Amplitudenbeträge der ersten Spannung sowie der dritten Spannung und/oder einen Amplitudenbetrag der zweiten Spannung in Abhängigkeit von dem Regelwert zu verändern.

2. Schaltungsanordnung (100, 1100, 1200, 1300) gemäß Anspruch 1, wobei die Schaltungsanordnung (100, 1100, 1200, 1300) einen vierten Kondensator (140) aufweist,
   wobei ein erster Kondensatorbelag (141) des vierten Kondensators (140) mit dem ersten Schaltungsknoten (101) verbunden ist,
   wobei die Schaltungsanordnung (100, 1100, 1200, 1300) ausgebildet ist, den vierten Kondensator (140) mit einer vierten zeitabhängigen Spannung zu beaufschlagen,
   wobei die erste Spannung und die vierte Spannung gleichphasig getaktet sind.

3. Schaltungsanordnung (100, 1200) gemäß einem der Ansprüche 1 oder 2, wobei die Schaltungsanordnung (100, 1200) eine regelbare Gleichstromquelle (150, 160, 170, 180) aufweist, die zwischen dem Massekontakt (103) und einem zweiten Kondensatorbelag (112, 122, 132, 142) des ersten Kondensators (110) oder des zweiten Kondensators (120) oder des dritten Kondensators (130) oder des vierten Kondensators (140) angeordnet ist, wobei die Schaltungsanordnung (100, 1200) einen Widerstand (155, 165, 175, 185) aufweist, der zwischen dem zweiten Kondensatorbelag (112, 122, 132, 142) und einem zweiten Schaltungsknoten (102) angeordnet ist, wobei der zweite Schaltungsknoten (102) dazu vorgesehen ist, sich auf einem gegenüber dem Massekontakt (103) erhöhten konstanten Potential zu befinden,
   wobei zwischen der Gleichstromquelle (150, 160, 170, 180) und dem zweiten Kondensatorbelag (112, 122, 132, 142) ein Schalter (154, 164, 174, 184) angeordnet ist.

4. Schaltungsanordnung (100) gemäß Ansprüchen 2 und 3,
   wobei die Schaltungsanordnung (100) eine erste regelbare Gleichstromquelle (150), eine zweite regelbare Gleichstromquelle (160), eine dritte regelbare Gleichstromquelle (170), eine vierte regelbare Gleichstromquelle (180), einen ersten Schalter (154), einen zweiten Schalter (164), einen dritten Schalter (174), einen vierten Schalter (184), einen ersten Widerstand (155), einen zweiten Widerstand (165), einen dritten Widerstand (175) und einen vierten Widerstand (185) umfasst,
   wobei der erste Schalter (154) zwischen dem zweiten Kondensatorbelag (112) des ersten Kondensators (110) und einem ersten Kontakt (151) der ersten Gleichstromquelle (150) angeordnet ist,
   wobei ein zweiter Kontakt (152) der ersten Gleichstromquelle (150) mit dem Massekontakt (103) verbunden ist,
   wobei der erste Widerstand (155) zwischen dem zweiten Kondensatorbelag (112) des ersten Kondensators (110) und dem zweiten Schaltungsknoten (102) angeordnet ist,

wobei der zweite Schalter (164) zwischen dem zweiten Kondensatorbelag (122) des zweiten Kondensators (120) und einem ersten Kontakt (161) der zweiten Gleichstromquelle (160) angeordnet ist, wobei ein zweiter Kontakt (162) der zweiten Gleichstromquelle (160) mit dem Massekontakt (103) verbunden ist, wobei der zweite Widerstand (165) zwischen dem zweiten Kondensatorbelag (122) des zweiten Kondensators (120) und dem zweiten Schaltungsknoten (102) angeordnet ist, wobei der dritte Schalter (174) zwischen dem zweiten Kondensatorbelag (132) des dritten Kondensators (130) und einem ersten Kontakt (171) der dritten Gleichstromquelle (170) angeordnet ist, wobei ein zweiter Kontakt (172) der dritten Gleichstromquelle (170) mit dem Massekontakt (103) verbunden ist, wobei der dritte Widerstand (175) zwischen dem zweiten Kondensatorbelag (132) des dritten Kondensators (130) und dem zweiten Schaltungsknoten (102) angeordnet ist, wobei der vierte Schalter (184) zwischen dem zweiten Kondensatorbelag (142) des vierten Kondensators (140) und einem ersten Kontakt (181) der vierten Gleichstromquelle (180) angeordnet ist, wobei ein zweiter Kontakt (182) der vierten Gleichstromquelle (180) mit dem Massekontakt (103) verbunden ist, wobei der vierte Widerstand (185) zwischen dem zweiten Kondensatorbelag (142) des vierten Kondensators (140) und dem zweiten Schaltungsknoten (102) angeordnet ist.

5. Schaltungsanordnung (1200) gemäß Anspruch 3, wobei die Schaltungsanordnung (1200) einen invertierenden Verstärker (1210) aufweist, wobei ein invertierender Eingang (1211) des invertierenden Verstärkers (1210) über einen ersten Widerstand (1220) mit dem zweiten Kondensatorbelag (112, 122, 132, 142) verbunden ist, wobei ein nicht-invertierender Eingang (1212) des invertierenden Verstärkers (1210) mit einem dritten Schaltungsknoten (1201) verbunden ist, wobei der dritte Schaltungsknoten (1201) dazu vorgesehen ist, sich auf einem konstanten Potential zu befinden, dass mittig zwischen dem Potential des zweiten Schaltungsknotens (102) und dem Potential des Massekontakts (103) liegt, wobei ein Ausgang (1213) des invertierenden Verstärkers (1210) über einen zweiten Widerstand (1230) mit dem invertierenden Eingang (1210) des invertierenden Verstärkers (1210) verbunden ist, wobei der Ausgang (1213) des invertierenden Verstärkers (1210) mit einem weiteren zweiten Kondensatorbelag (112, 122, 132, 142) eines weiteren Kondensators (110, 120, 130, 140) verbunden ist.

6. Schaltungsanordnung (1100) gemäß einem der Ansprüche 1 oder 2, wobei die Schaltungsanordnung (1100) eine regelbare Gleichspannungsquelle (1150) aufweist, die zwischen dem Massekontakt (103) und einem zweiten Kondensatorbelag (112, 122, 132, 142) des ersten Kondensators (110) oder des zweiten Kondensators (120) oder des dritten Kondensators (130) oder des vierten Kondensators (140) angeordnet ist, wobei zwischen der Gleichspannungsquelle (1150) und dem zweiten Kondensatorbelag (112, 122, 132, 142) ein weiterer Schalter (1154) angeordnet ist, der dazu ausgebildet ist, den zweiten Kondensatorbelag (112, 122, 132, 142) entweder mit der Gleichspannungsquelle (1150) oder mit dem Massekontakt (103) zu verbinden.

7. Schaltungsanordnung (100, 1100, 1200) gemäß einem der Ansprüche 1 bis 6, wobei die Schaltungsanordnung (100, 1100, 1200) einen Taktgenerator (190) umfasst, der dazu ausgebildet ist, ein Taktsignal und ein zum Taktsignal inverses Gegentaktsignal zu erzeugen, wobei die Schaltungsanordnung (100, 1100, 1200) ausgebildet ist, den Synchrondemodulator (210) mittels des Taktsignals anzusteuern, wobei die Schaltungsanordnung (100, 1100, 1200) ferner ausgebildet ist, die erste Spannung mittels des Taktsignals zu takten und die zweite Spannung mittels des Gegentaktsignals zu takten.

8. Schaltungsanordnung (1300) gemäß einem der Ansprüche 1 oder 2, wobei die Schaltungsanordnung (1300) eine regelbare Wechselstromquelle (1350, 1360, 1370, 1380) aufweist, die zwischen dem Massekontakt (103) und einem zweiten Kondensatorbelag (112, 122, 132, 142) des ersten Kondensators (110) oder des zweiten Kondensators (120) oder des dritten Kondensators (130) oder des vierten Kondensators (140) angeordnet ist, wobei die Schaltungsanordnung (1300) einen Widerstand (155, 165, 175, 185) aufweist, der zwischen dem zweiten Kondensatorbelag (112, 122, 132, 142) und einem zweiten Schaltungsknoten (102) angeordnet ist, wobei der zweite Schaltungsknoten (102) dazu vorgesehen ist, sich auf einem gegenüber dem Massekontakt (103) erhöhten konstanten Potential zu befinden.

9. Schaltungsanordnung (100, 1100, 1200, 1300) gemäß einem der Ansprüche 1 bis 8, wobei der Komparator (220) ein integrierender Komparator oder ein Sample-and-Hold-Komparator ist.

**10.** Balkendetektor (300, 310, 320, 330, 340, 350, 360, 370, 380, 390, 400, 410, 420,430) mit einer Schaltungsanordnung (100, 1100, 1200, 1300) gemäß einem der vorhergehenden Ansprüche.

**11.** Balkendetektor (300, 310, 320, 330, 340, 350, 360, 370, 380, 390, 400, 410, 420, 430) gemäß Anspruch 10, wobei der Balkendetektor eine erste Elektrode (301, 311, 321, 331, 341, 351, 361, 371, 381, 391, 401, 411, 421, 431) und eine zweite Elektrode (302, 312, 322, 332, 342, 352, 362, 372, 382, 392, 402, 412, 422, 432) aufweist, wobei die erste Elektrode den zweiten Kondensatorbelag (112) des ersten Kondensators (110) bildet, wobei die zweite Elektrode den ersten Kondensatorbelag (111) des ersten Kondensators (110) bildet.

**12.** Balkendetektor (310, 410, 420, 430) gemäß Anspruch 11, wobei der Balkendetektor (310, 410, 420, 430) eine dritte Elektrode (313, 413, 423, 433) aufweist, wobei die erste Elektrode (311, 411, 421, 431) und die dritte Elektrode (313, 413, 423, 433) gemeinsam den zweiten Kondensatorbelag (112) des ersten Kondensators (110) bilden.

**13.** Balkendetektor (410, 420, 430) gemäß Anspruch 12, wobei die Schaltungsanordnung (100, 1100, 1200, 1300) gemäß Anspruch 2 ausgebildet ist, wobei der Balkendetektor (410, 420, 430) eine vierte Elektrode (414, 424, 434) und eine fünfte Elektrode (415, 425, 435) aufweist, wobei die vierte Elektrode (414, 424, 434) und die fünfte Elektrode (415, 425, 435) gemeinsam den zweiten Kondensatorbelag (122, 132, 142) des zweiten Kondensators (120) oder des dritten Kondensators (130) oder des vierten Kondensators (140) bilden, wobei die zweite Elektrode (412, 422, 432) den ersten Kondensatorbelag (121, 131, 141) dieses Kondensators (120, 130, 140) bildet.

**14.** Balkendetektor (320, 330, 340, 350, 360, 370, 380, 390, 400) gemäß Anspruch 11, wobei der Balkendetektor (320, 330, 340, 350, 360, 370, 380, 390, 400) eine dritte Elektrode (323, 333, 343, 353, 363, 373, 383, 393, 403) aufweist, wobei die dritte Elektrode und die zweite Elektrode (322, 332, 342, 352, 362, 372, 382, 392, 402) den zweiten Kondensator (120), den dritten Kondensator (130) oder den vierten Kondensator (140) bilden.

**15.** Balkendetektor (350, 360, 370, 380, 390, 400) gemäß Anspruch 14, wobei die Schaltungsanordnung (100, 1100, 1200, 1300) gemäß Anspruch 2 ausgebildet ist, wobei der Balkendetektor (350, 360, 370, 380, 390, 400) eine vierte Elektrode (354, 364, 374, 384, 394, 404) und eine fünfte Elektrode (355, 365, 375, 385, 395, 405) aufweist, wobei die vierte Elektrode und die zweite Elektrode (352, 362, 372, 382, 392, 402) sowie die fünfte Elektrode und die zweite Elektrode die beiden nicht mit der ersten Elektrode (351, 361, 371, 381, 391, 401) und mit der dritten Elektrode (353, 363, 373, 383, 393, 403) gebildeten Kondensatoren (120, 130, 140) bilden.

**16.** Balkendetektor (310, 320, 330, 340, 350, 360, 370, 380, 390, 400, 410, 420, 430) gemäß einem der Ansprüche 12 bis 15, wobei die zweite Elektrode zwischen der ersten Elektrode und der dritten Elektrode angeordnet ist.

**17.** Balkendetektor (300, 310, 320, 330, 340, 350, 360, 370, 380, 390, 400, 410, 420, 430) gemäß einem der Ansprüche 11 bis 16, wobei die nicht durch Elektroden gebildeten Kondensatoren der Schaltungsanordnung (100, 1100, 1200, 1300) als Festwertkondensatoren ausgebildet sind.

**18.** Balkendetektor (300, 310, 320, 330, 340, 350, 360, 370, 380, 390, 400, 410, 420, 430) gemäß einem der Ansprüche 11 bis 17, wobei die Elektroden als metallische Platten ausgebildet sind.

**Claims**

**1.** Circuit arrangement (100, 1100, 1200, 1300) with a first capacitor (110), a second capacitor (120) and a third capacitor (130), wherein first capacitor foils (111, 121, 131) of the capacitors (110, 120, 130) are connected in each case to a first circuit node (101),

wherein the circuit arrangement (100, 1100, 1200, 1300) is designed to supply the first capacitor (110) with a first time-dependent voltage, to supply the second capacitor (120) with a second time-dependent voltage and to supply the third capacitor (130) with a third time-dependent voltage,

wherein the first voltage and the second voltage are clocked in antiphase,

wherein the second voltage and the third voltage are clocked in phase,

wherein the circuit arrangement (100, 1100, 1200, 1300) comprises an amplifier (200), a synchronous demodulator (210) and a comparator (220),

wherein inputs (201, 202) of the amplifier (200) are connected to the first circuit node (101) and to a ground contact (103),

wherein the synchronous demodulator (210) is provided for applying an output signal of the amplifier (200) synchronously with the clock of the first voltage alternately to two inputs (221, 222) of the comparator (220),

wherein the circuit arrangement (100, 1100, 1200, 1300) is designed to generate a control value in dependence on an output value of the comparator (220),

wherein the circuit arrangement (100, 1100, 1200, 1300) is also designed for changing amplitude amounts of the first voltage and of the third voltage and/or an amplitude amount of the second voltage in dependence on the control value.

**2.** Circuit arrangement (100, 1100, 1200, 1300) according to Claim 1,

wherein the circuit arrangement (100, 1100, 1200, 1300) has a fourth capacitor (140),

wherein a first capacitor foil (141) of the fourth capacitor (140) is connected to the first circuit node (101),

wherein the circuit arrangement (100, 1100, 1200, 1300) is designed to supply the fourth capacitor (140) with a fourth time-dependent voltage, wherein the first voltage and the fourth voltage are clocked in phase.

**3.** Circuit arrangement (100, 1200) according to either of Claims 1 and 2,

wherein the circuit arrangement (100, 1200) has a controllable direct-current source (150, 160, 170, 180) which is arranged between the ground contact (103) and a second capacitor foil (112, 122, 132, 142) of the first capacitor (110) or of the second capacitor (120) or of the third capacitor (130) or of the fourth capacitor (140),

wherein the circuit arrangement (100, 1200) has a resistor (155, 165, 175, 185) which is arranged between the second capacitor foil (112, 122, 132, 142) and a second circuit node (102),

wherein the second circuit node (102) is provided for being at a constant potential increased compared with the ground contact (103),

wherein a switch (154, 164, 174, 184) is arranged between the direct-current source (150, 160, 170, 180) and the second capacitor foil (112, 122, 132, 142).

**4.** Circuit arrangement (100) according to Claims 2 and 3,

wherein the circuit arrangement (100) comprises a first controllable direct-current source (150), a second controllable direct-current source (160), a third controllable direct-current source (170), a fourth controllable direct-current source (180), a first switch (154), a second switch (164), a third switch (174), a fourth switch (184), a first resistor (155), a second resistor (165), a third resistor (175) and a fourth resistor (185), wherein the first switch (154) is arranged between the second capacitor foil (112) of the first capacitor (110) and a first contact (151) of the first direct-current source (150),

wherein a second contact (152) of the first direct-current source (150) is connected to the ground contact (103),

wherein the first resistor (155) is arranged between the second capacitor foil (112) of the first capacitor (110) and the second circuit node (102),

wherein the second switch (164) is arranged between the second capacitor foil (122) of the second capacitor (120) and a first contact (161) of the second direct-current source (160),

wherein a second contact (162) of the second direct-current source (160) is connected to the ground contact (103),

wherein the second resistor (165) is arranged between the second capacitor foil (122) of the second capacitor (120) and the second circuit node (102),

wherein the third switch (174) is arranged between the second capacitor foil (132) of the third capacitor (130) and a first contact (171) of the third direct-current source (170),

wherein a second contact (172) of the third direct-current source (170) is connected to the ground contact (103),

wherein the third resistor (175) is arranged between the second capacitor foil (132) of the third capacitor (130) and the second circuit node (102),

wherein the fourth switch (184) is arranged between the second capacitor foil (142) of the fourth capacitor (140) and a first contact (181) of the fourth direct-current source (180), wherein a second contact (182) of the fourth direct-current source (180) is connected to the ground contact (103),

wherein the fourth resistor (185) is arranged between the second capacitor foil (142) of the fourth capacitor (140) and the second circuit node (102).

5. Circuit arrangement (1200) according to Claim 3, wherein the circuit arrangement (1200) has an inverting amplifier (1210),
wherein an inverting input (1211) of the inverting amplifier (1210) is connected to the second capacitor foil (112, 122, 132, 142) via a first resistor (1220),
wherein a non-inverting input (1212) of the inverting amplifier (1210) is connected to a third circuit node (1201),
wherein the third circuit node (1201) is provided for being at a constant potential which is located centrally between the potential of the second circuit node (102) and the potential of the ground contact (103),
wherein an output (1213) of the inverting amplifier (1210) is connected to the inverting input (1210) of the inverting amplifier (1210) via a second resistor (1230),
wherein the output (1213) of the inverting amplifier (1210) is connected to a further second capacitor foil (112, 122, 132, 142) of a further capacitor (110, 120, 130, 140).

6. Circuit arrangement (1100) according to either of Claims 1 and 2,
wherein the circuit arrangement (1100) has a controllable direct-voltage source (1150) which is arranged between the ground contact (103) and a second capacitor foil (112, 122, 132, 142) of the first capacitor (110) or of the second capacitor (120) or of the third capacitor (130) or of the fourth capacitor (140),
wherein between the direct-voltage source (1150) and the second capacitor foil (112, 122, 132, 142), a further switch (1154) is arranged which is designed for connecting the second capacitor foil (112, 122, 132, 142) either to the direct-voltage source (1150) or to the ground contact (103).

7. Circuit arrangement (100, 1100, 1200) according to one of Claims 1 to 6,
wherein the circuit arrangement (100, 1100, 1200) comprises a clock generator (190) which is designed to generate a clock signal and a push-pull signal inverse to the clock signal, wherein the circuit arrangement (100, 1100, 1200) is designed to drive the synchronous demodulator (210) by means of the clock signal,
wherein the circuit arrangement (100, 1100, 1200) is also designed to clock the first voltage by means of the clock signal and to clock the second voltage by means of the push-pull signal.

8. Circuit arrangement (1300) according to either of Claims 1 and 2,
wherein the circuit arrangement (1300) has a controllable alternating-current source (1350, 1360, 1370, 1380) which is arranged between the ground contact (103) and a second capacitor foil (112, 122, 132, 142) of the first capacitor (110) or of the second capacitor (120) or of the third capacitor (130) or of the fourth capacitor (140), wherein the circuit arrangement (1300) has a resistor (155, 165, 175, 185) which is arranged between the second capacitor foil (112, 122, 132, 142) and a second circuit node (102),
wherein the second circuit node (102) is provided for being at a constant potential increased compared with the ground contact (103).

9. Circuit arrangement (100, 1100, 1200, 1300) according to one of Claims 1 to 8,
wherein the comparator (220) is an integrating comparator or a sample-and-hold comparator.

10. Beam detector (300, 310, 320, 330, 340, 350, 360, 370, 380, 390, 400, 410, 420, 430)
with a circuit arrangement (100, 1100, 1200, 1300) according to one of the preceding claims.

11. Beam detector (300, 310, 320, 330, 340, 350, 360, 370, 380, 390, 400, 410, 420, 430) according to Claim 10,
wherein the beam detector has a first electrode (301, 311, 321, 331, 341, 351, 361, 371, 381, 391, 401, 411, 421, 431) and a second electrode (302, 312, 322, 332, 342, 352, 362, 372, 382, 392, 402, 412, 422, 432),
wherein the first electrode forms the second capacitor foil (112) of the first capacitor (110), wherein the second electrode forms the first capacitor foil (111) of the first capacitor (110).

12. Beam detector (310, 410, 420, 430) according to Claim 11,
wherein the beam detector (310, 410, 420, 430) has a third electrode (313, 413, 423, 433),
wherein the first electrode (311, 411, 421, 431) and the third electrode (313, 413, 423, 433) jointly form the second capacitor foil (112) of the first capacitor (110).

13. Beam detector (410, 420, 430) according to Claim 12,
wherein the circuit arrangement (100, 1100, 1200, 1300) is designed according to Claim 2,
wherein the beam detector (410, 420, 430) has a fourth electrode (414, 424, 434) and a fifth electrode (415, 425, 435),

**EP 2 862 277 B1**

wherein the fourth electrode (414, 424, 434) and the fifth electrode (415, 425, 435) jointly form the second capacitor foil (122, 132, 142) of the second capacitor (120) or of the third capacitor (130) or of the fourth capacitor (140), wherein the second electrode (412, 422, 432) forms the first capacitor foil (121, 131, 141) of this capacitor (120, 130, 140).

14. Beam detector (320, 330, 340, 350, 360, 370, 380, 390, 400) according to Claim 11,
wherein the beam detector (320, 330, 340, 350, 360, 370, 380, 390, 400) has a third electrode (323, 333, 343, 353, 363, 373, 383, 393, 403), wherein the third electrode and the second electrode (322, 332, 342, 352, 362, 372, 382, 392, 402) form the second capacitor (120), the third capacitor (130) or the fourth capacitor (140).

15. Beam detector (350, 360, 370, 380, 390, 400) according to Claim 14, wherein the circuit arrangement (100, 1100, 1200, 1300) is designed according to Claim 2,
wherein the beam detector (350, 360, 370, 380, 390, 400) has a fourth electrode (354, 364, 374, 384, 394, 404) and a fifth electrode (355, 365, 375, 385, 395, 405),
wherein the fourth electrode and the second electrode (352, 362, 372, 382, 392, 402) and the fifth electrode and the second electrode form the two capacitors (120, 130, 140) not formed with the first electrode (351, 361, 371, 381, 391, 401) and with the third electrode (353, 363, 373, 383, 393, 403).

16. Beam detector (310, 320, 330, 340, 350, 360, 370, 380, 390, 400, 410, 420, 430) according to one of Claims 12 to 15,
wherein the second electrode is arranged between the first electrode and the third electrode.

17. Beam detector (300, 310, 320, 330, 340, 350, 360, 370, 380, 390, 400, 410, 420, 430) according to one of Claims 11 to 16,
wherein the capacitors of the circuit arrangement (100, 1100, 1200, 1300) not formed by electrodes are designed as fixed-value capacitors.

18. Beam detector (300, 310, 320, 330, 340, 350, 360, 370, 380, 390, 400, 410, 420, 430) according to one of Claims 11 to 17,
wherein the electrodes are designed as metallic plates.

**Revendications**

1. Circuit (100, 1100, 1200, 1300), présentant un premier condensateur (110), un deuxième condensateur (120) et un troisième condensateur (130),
des premières plaques (111, 121, 131) des condensateurs (110, 120, 130) étant toutes reliées à un premier noeud (101) du circuit,
circuit (100, 1100, 1200, 1300) étant configuré pour appliquer sur le premier condensateur (110) une première tension variant en fonction du temps, pour appliquer sur le deuxième condensateur (120) une deuxième tension variant en fonction du temps et pour appliquer sur le troisième condensateur (130) une troisième tension variant en fonction du temps,
la première tension et la deuxième tension étant cadencées en opposition de phase,
la deuxième tension et la troisième tension étant cadencées en concordance de phase,
le circuit (100, 1100, 1200, 1300) comportant un amplificateur (200), un démodulateur synchrone (210) et un comparateur (220),
des entrées (201, 202) de l'amplificateur (200) étant raccordées au premier noeud (101) du circuit et à un contact de masse (103),
le démodulateur synchrone (210) étant prévu pour appliquer un signal de sortie de l'amplificateur (200) de manière synchronisée sur la cadence de la première tension en variante sur deux entrées (221, 222) du comparateur (220),
le circuit (100, 1100, 1200, 1300) étant configuré pour produire une valeur de régulation en fonction de la valeur de sortie du comparateur (220) et
le circuit (100, 1100, 1200, 1300) étant en outre configuré pour modifier les valeurs d'amplitude de la première tension ainsi que de la troisième tension et/ou une valeur d'amplitude de la deuxième tension en fonction de la valeur de régulation.

2. Circuit (100, 1100, 1200, 1300) selon la revendication 1, dans lequel le circuit (100, 1100, 1200, 1300) présente un quatrième condensateur (140), une première plaque (141) du quatrième condensateur (140) étant raccordée au premier noeud (101) du circuit,

20

le circuit (100, 1100, 1200, 1300) étant configuré pour appliquer sur le quatrième condensateur (140) une quatrième tension variant en fonction du temps, la première tension et la quatrième tension étant cadencées en concordance de phase.

3. Circuit (100, 1200) selon l'une des revendications 1 ou 2, dans lequel le circuit (100, 1200) présente une source régulable (150, 160, 170, 180) de courant continu disposée entre le contact de masse (103) et une deuxième plaque (112, 122, 132, 142) du premier condensateur (110), du deuxième condensateur (120), du troisième condensateur (130) ou du quatrième condensateur (140), le circuit (100, 1200) présentant une résistance (155, 165, 175, 185) disposée entre la deuxième plaque (112, 122, 132, 142) de condensateur et un deuxième noeud (102) du circuit, les deux noeuds (102) du circuit étant prévus pour être placés à un potentiel constant plus élevé que celui du contact de masse (103) et un commutateur (154, 164, 174, 184) étant disposé entre la source (150, 160, 170, 180) du courant continu et la deuxième plaque (112, 122, 132, 142) de condensateur.

4. Circuit (100) selon les revendications 2 et 3, dans lequel le circuit (100) comporte une première source (150) de courant régulable, une deuxième source (160) de courant régulable, une troisième source (170) de courant régulable, une quatrième source (180) de courant régulable, un premier commutateur (154), un deuxième commutateur (164), un troisième commutateur (174), un quatrième commutateur (184), une première résistance (155), une deuxième résistance (165), une troisième résistance (175) et une quatrième résistance (185),
le premier commutateur (154) étant disposé entre la deuxième plaque (112) du premier condensateur (110) et un premier contact (151) de la première source (150) de courant continu,
un deuxième contact (152) de la première source (150) de courant continu étant raccordé au contact de masse (103),
la première résistance (155) étant disposée entre la deuxième plaque (112) du premier condensateur (110) et le deuxième noeud (102) de circuit,
le deuxième commutateur (164) étant disposé entre la deuxième plaque (122) du deuxième condensateur (120) et un premier contact (161) de la deuxième source (160) de courant continu,
un deuxième contact (162) de la deuxième source (160) de courant continu étant raccordé au contact de masse (103),
la deuxième résistance (165) étant disposée entre la deuxième plaque (122) du deuxième condensateur (120) et le deuxième noeud (102) du circuit,
le troisième commutateur (174) étant disposé entre la deuxième plaque (132) du troisième condensateur (130) et un premier contact (171) de la troisième source (170) de courant continu,
un deuxième contact (172) de la troisième source (170) de courant continu étant raccordé au contact de masse (103),
la troisième résistance (175) étant disposée entre la deuxième plaque (132) du troisième condensateur (130) et le deuxième noeud (102) du circuit,
le quatrième commutateur (184) étant disposé entre la deuxième plaque (142) du quatrième condensateur (140) et un premier contact (181) de la quatrième source (180) de courant continu,
un deuxième contact (182) de la quatrième source (180) de courant continu étant raccordé au contact de masse (103) et
la quatrième résistance (185) étant disposée entre la deuxième plaque (142) du quatrième condensateur (140) et le deuxième noeud (102) du circuit.

5. Circuit (1200) selon la revendication 3, dans lequel le circuit (1200) présente un amplificateur inverseur (1210), une entrée inversante (1211) de l'amplificateur inverseur (1210) étant reliée par l'intermédiaire d'une première résistance (1220) à la deuxième plaque (112, 122, 132, 142) de condensateur, une entrée non inversante (1212) de l'amplificateur inverseur (1210) étant reliée à un troisième noeud (1201) du circuit,
le troisième noeud (1201) du circuit étant prévu pour être situé à un potentiel constant à un niveau situé au milieu entre le potentiel du deuxième noeud (102) du circuit et le potentiel du contact de masse (103),
une sortie (1213) de l'amplificateur inverseur (1210) étant reliée par une deuxième résistance (1230) à l'entrée inversante (1210) de l'amplificateur inverseur (1210) et
la sortie (1213) de l'amplificateur inverseur (1210) étant reliée à une autre deuxième plaque (112, 122, 132, 142) d'un autre condensateur (110, 120, 130, 140).

6. Circuit (1100) selon l'une des revendications 1 ou 2, dans lequel le circuit (1100) présente une source (1150) de tension régulable disposée entre le contact de masse (103) et une deuxième plaque (112, 122, 132, 142) du premier condensateur (110), du deuxième condensateur (120), du troisième condensateur (130) ou du quatrième condensateur (140),
un autre commutateur (1154) conçu pour relier la deuxième plaque (112, 122, 132, 142) de condensateur à la source (1150) de tension continue ou au contact de masse (103) étant disposée entre la source (1150) de tension continue et la deuxième plaque (112, 122, 132, 142) de condensateur.

**7.** Circuit (100, 1100, 1200) selon l'une des revendications 1 à 6, dans lequel le circuit (100, 1100, 1200) comporte un générateur d'horloge (190) configuré pour former un signal d'horloge et un signal complémentaire d'horloge inverse du signal d'horloge,

le circuit (100, 1100, 1200) étant configuré pour commander le démodulateur synchrone (210) au moyen du signal d'horloge, le circuit (100, 1100, 1200) étant en outre configuré pour cadencer la première tension au moyen du signal d'horloge et cadencer la deuxième tension au moyen du signal complémentaire d'horloge.

**8.** Circuit (1300) selon l'une des revendications 1 ou 2, dans lequel le circuit (1300) présente une source (1350, 1360, 1370, 1380) de courant alternatif régulable disposé entre le contact de masse (103) et une deuxième plaque (112, 122, 132, 142) du premier condensateur (110), du deuxième condensateur (120), du troisième condensateur (130) ou du quatrième condensateur (140),

le circuit (1300) présentant une résistance (155, 165, 175, 185) disposée entre la deuxième plaque (112, 122, 132, 142) de condensateur et un deuxième noeud (102) du circuit et

le deuxième noeud (102) du circuit étant prévu pour être situé à un potentiel constant plus élevé que celui du contact de masse (103).

**9.** Circuit (100, 1100, 1200, 1300) selon l'une des revendications 1 à 8, dans lequel le comparateur (220) est un comparateur intégrateur ou un comparateur d'échantillonnage et de maintien.

**10.** Détecteur de poutre (300, 310, 320, 330, 340, 350, 360, 370, 380, 390, 400, 410, 420, 430) doté d'un circuit (100, 1100, 1200, 1300) selon l'une des revendications précédentes.

**11.** Détecteur de poutre (300, 310, 320, 330, 340, 350, 360, 370, 380, 390, 400, 410, 420, 430) selon la revendication 10, dans lequel le détecteur de poutre présente une première électrode (301, 311, 321, 331, 341, 351, 361, 371, 381, 391, 401, 411, 421, 431) et une deuxième électrode (302, 312, 322, 332, 342, 352, 362, 372, 382, 392, 402, 412, 422, 432), la première électrode formant la deuxième plaque (112) du premier condensateur (110) et la deuxième électrode formant la première plaque (111) du premier condensateur (110).

**12.** Détecteur de poutre (310, 410, 420, 430) selon la revendication 11, dans lequel le détecteur de poutre (310, 410, 420, 430) présente une troisième électrode (313, 413, 423, 433), la première électrode (311, 411, 421, 431) et la troisième électrode (313, 413, 423, 433) formant ensemble la deuxième plaque (112) du deuxième condensateur (110).

**13.** Détecteur de poutre (410, 420, 430) selon la revendication 12, dans lequel le circuit (100, 1100, 1200, 1300) selon la revendication 2 est formé, le détecteur de poutre (410, 420, 430) présentant une quatrième électrode (414, 424, 434) et une cinquième électrode (415, 425, 435),

la quatrième électrode (414, 424, 434) et la cinquième électrode (415, 425, 435) formant ensemble la deuxième plaque (122, 132, 142) du deuxième condensateur (120), du troisième condensateur (130) ou du quatrième condensateur (140), la deuxième électrode (412, 422, 432) formant la première plaque (121, 131, 141) de ses condensateurs (120, 130, 140).

**14.** Détecteur de poutre (320, 330, 340, 350, 360, 370, 380, 390, 400) selon la revendication 11, le détecteur de poutre (320, 330, 340, 350, 360, 370, 380, 390, 400) présentant une troisième électrode (323, 333, 343, 353, 363, 373, 383, 393, 403), la troisième électrode et la deuxième électrode (322, 332, 342, 352, 362, 372, 382, 392, 402) formant le deuxième concentrateur (120), le troisième condensateur (130) ou la quatrième condensateur (140).

**15.** Détecteur de poutre (350, 360, 370, 380, 390, 400) selon la revendication 14, dans lequel le circuit (100, 1100, 1200, 1300) selon la revendication 2 est formé, le détecteur de poutre (350, 360, 370, 380, 390, 400) présentant une quatrième électrode (354, 364, 374, 384, 394, 404) et une cinquième électrode (355, 365, 375, 385, 395, 405), la quatrième électrode et la deuxième électrode (352, 362, 372, 382, 392, 402) ainsi que la cinquième électrode et la deuxième électrode formant les deux condensateurs (120, 130, 140) non formés avec la première électrode (351, 361, 371, 381, 391, 401) et la troisième électrode (353, 363, 373, 383, 393, 403).

**16.** Détecteur de poutre (310, 320, 330, 340, 350, 360, 370, 380, 390, 400, 410, 420, 430) selon l'une des revendications 12 à 15, dans lequel la deuxième électrode est disposée entre la première électrode et la troisième électrode.

**17.** Détecteur de poutre (300, 310, 320, 330, 340, 350, 360, 370, 380, 390, 400, 410, 420, 430) selon l'une des revendications 11 à 16, dans lequel les condensateurs du circuit (100, 1100, 1200, 1300) non formés par les électrodes sont configurés comme condensateurs de valeur fixe.

18. Détecteur de poutre (300, 310, 320, 330, 340, 350, 360, 370, 380, 390, 400, 410, 420, 430) selon l'une des revendications 11 à 17, dans lequel les électrodes sont configurées sous la forme de plaques métalliques.

Fig. 1

EP 2 862 277 B1

24

**Fig. 2**

**Fig. 3**

Fig. 4

EP 2 862 277 B1

Fig. 5

Fig. 6

Fig. 7

330

112,331    111,121,332    122,333

130    140

104    101    105
106    107

**Fig. 8**

340

112,341    111,131,342    132,343

140    120

104    101    106
107    105

**Fig. 9**

500

502

510

501

520

**Fig. 10**

**Fig. 11**

**Fig. 12**

**Fig. 13**

**Fig. 14**

EP 2 862 277 B1

Fig. 15

Fig. 16

Fig. 17

Fig. 18

30

390

111,121,131,141,392

122,394        132,395

112,391                    142,393

104   101   107
     105  106

## Fig. 19

400

111,121,131,141,402

132,404        122,405

112,401                    142,403

104  101  107
     106  105

## Fig. 20

640

392
641        642

391 | 394        395 | 393

104   101   107
     105  106

## Fig. 21

650

402
651        652

401 | 404        405 | 403

104   101   107
     106  105

## Fig. 22

31

Fig. 23

Fig. 24

Fig. 25

**Fig. 26**

**Fig. 27**

**Fig. 28**

**Fig. 29**

**Fig. 30**

EP 2 862 277 B1

Fig. 31

Fig. 32

EP 2 862 277 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102010028718

**In der Beschreibung aufgeführte Nicht-Patentliteratur**

- **LARRY K. BAXTER.** Capacitive sensors. IEEE Press